# EUROPEAN PATENT APPLICATION

(11) **EP 4 797 929 A2**
(43) Date of publication of application: **26.08.2026**
(21) Application number: 26156182.3
(22) Date of filing: 03.02.2026
(51) Int. Cl.: H10P 72/00

(54) **SUBSTRATE PROCESSING APPARATUS AND SUBSTRATE PROCESSING METHOD**

(30) Priority: 19.02.2025 JP 2025025322
(71) Applicant: SCREEN Holdings Co., Ltd., Kyoto-shi, Kyoto 602-8585 (JP)
(72) Inventor: ENDO, Toru, Kyoto, 602-8585 (JP); SHIRAI, Takeshi, Kyoto, 602-8585 (JP); SADA, Akihiro, Kyoto, 602-8585 (JP); ODANI, Kaito, Kyoto, 602-8585 (JP); AOKI, Rikuta, Kyoto, 602-8585 (JP)
(74) Representative: Kilian Kilian & Partner mbB

(57) **Abstract**

A substrate processing apparatus includes a substrate holder, a nozzle, a liquid flow path, an adjustment valve that adjusts a flow rate of the processing liquid flowing through the liquid flow path, a nozzle movement device that moves the nozzle, and a controller that controls the nozzle movement device based on a nozzle movement condition and controls an adjustment valve based on a valve condition. The nozzle movement condition includes a plurality of portion movement information pieces defining movement speeds of the nozzle when the nozzle moves through the plurality of portions of the substrate. The valve condition includes a plurality of valve control information pieces representing methods of controlling the valve when the nozzle moves through the plurality of portions of the substrate. The plurality of valve control information pieces include first valve control information, and second valve control information different from the first valve control information.

## Description

### BACKGROUND

### Technical Field

The present disclosure relates to a substrate processing apparatus and a substrate processing method for executing a predetermined process using a processing liquid on a substrate.

### Description of Related Art

A substrate processing apparatus is used to execute various processes on a substrate such as a semiconductor substrate, a substrate for an FPD (Flat Panel Display) that is used for a liquid crystal display device, an organic EL (Electro Luminescence) display device or the like, a substrate for an optical disc, a substrate for a magnetic disc, a substrate for a magneto-optical disc, a substrate for a photomask, a ceramic substrate or a substrate for a solar cell.

As one example of such a substrate processing apparatus, JP 2019-54019 A describes a substrate processing apparatus that executes a predetermined process using a processing liquid on one surface of a substrate. In the substrate processing apparatus, the processing liquid is discharged from a nozzle to the main surface of a substrate with the substrate held and rotated by a rotation holder. The nozzle is moved in a direction intersecting with the rotation center of the substrate in this state, so that an arrival position of the processing liquid on the substrate is moved. Thus, the processing liquid is supplied to the entire one surface of the substrate, and the one surface of the substrate is processed.

JP 2019-54104 A further describes that a speed profile in regard to the movement speed of the arrival position of the processing liquid (hereinafter referred to as a liquid-position movement speed) is set in order to improve uniformity of the process executed on the one surface of the substrate.

### SUMMARY

Meanwhile, excessive consumption of the processing liquid used for a substrate process increases the cost required for the substrate process. Further, in a case in which a chemical liquid, an organic solvent or the like is used as the processing liquid, it is preferable that wasteful consumption of the processing liquid is reduced as much as possible from the viewpoint of environmental protection.

As such, it is set that the processing liquid is supplied to a portion to be processed (a portion in which a circuit pattern is formed, for example) out of a plurality of portions on the one surface of the substrate at a first flow rate required for the process, for example. Further, it is set that the processing liquid is supplied to a portion not to be processed (a portion in which a circuit pattern is not formed, for example) out of the plurality of portions on the one surface of the substrate at a second flow rate lower than the first flow rate. In these cases, it is possible to reduce wasteful consumption of the processing liquid.

However, in a case in which the processing liquid is supplied to the plurality of portions of the substrate at different flow rates as described above, the control of the flow rate of the processing liquid to be supplied to the substrate may not follow the liquid-position movement speed depending on the type of the processing liquid and the magnitude of the liquid position movement speed. When an appropriate amount of the processing liquid is not supplied to the plurality of portions of the substrate, it is difficult to process the substrate with high accuracy.

An object of the present disclosure is to provide a substrate processing apparatus and a substrate processing method that enable execution of a process on a substrate with high accuracy while reducing wasteful consumption of a processing liquid.

A substrate processing apparatus according to one aspect of the present disclosure includes a substrate holder that holds and rotates a substrate, a nozzle that downwardly discharges a processing liquid, a processing liquid supply system that includes a liquid flow path and a valve and supplies the processing liquid to the nozzle, the liquid flow path being connected to the nozzle, the valve adjusting a flow rate of the processing liquid flowing through the liquid flow path, a movement driver that moves the nozzle to a plurality of different portions in a radial direction on an upper surface of the substrate while maintaining the nozzle above the substrate held by the substrate holder, and a controller that controls the movement driver based on a nozzle movement condition, and controls the valve based on a valve condition, wherein the nozzle movement condition includes a plurality of portion movement information pieces, the plurality of portion movement information pieces defining movement speeds of the nozzle when the nozzle moves through the plurality of respective portions for supply of the processing liquid to the plurality of respective portions of the substrate, the valve condition includes a plurality of valve control information pieces representing methods of controlling the valve when the nozzle moves through the plurality of respective portions, and the plurality of valve control information pieces include first valve control information corresponding to one portion of the plurality of portions of the substrate, and the second valve control information that corresponds to another portion of the plurality of portions of the substrate and is different from the first valve control information.

A substrate processing method according to another aspect of the present disclosure of processing a substrate using a substrate processing apparatus, wherein the substrate processing apparatus includes a nozzle that downwardly discharges a processing liquid, a liquid flow path connected to the nozzle, and a valve that adjusts a flow rate of the processing liquid flowing through the liquid flow path, the substrate processing method includes holding and rotating the substrate using a substrate holder, based on a nozzle movement condition, moving the nozzle to a plurality of different portions in a radial direction on an upper surface of the substrate while maintaining the nozzle above the substrate held by the substrate holder, and based on a valve condition, adjusting a flow rate of the processing liquid flowing through the liquid flow path to the nozzle, the nozzle movement condition includes a plurality of portion movement information pieces, with the plurality of portion movement information pieces defining movement speeds of the nozzle when the nozzle moves through the plurality of respective portions of the substrate for supply of the processing liquid to the plurality of respective portions of the substrate, the valve condition includes a plurality of valve control information pieces representing methods of controlling the valve when the nozzle moves through the plurality of respective portions, and the plurality of valve control information pieces include first valve control information corresponding to one portion of the plurality of portions of the substrate, and second valve control information that corresponds to another portion of the plurality of portions of the substrate and is different from the first valve control information.

With the present disclosure, it is possible to process a substrate with high accuracy while reducing wasteful consumption of a processing liquid.

Other features, elements, characteristics, and advantages of the present disclosure will become more apparent from the following description of preferred embodiments of the present disclosure with reference to the attached drawings.

### BRIEF DESCRIPTION OF THE DRAWING

Fig. 1 is a schematic diagram for explaining the configuration of a substrate processing apparatus according to one embodiment of the present disclosure;
Fig. 2 is a schematic plan view of the substrate processing apparatus of Fig. 1;
Fig. 3 is a diagram showing one example of a nozzle movement condition and a target flow-rate condition;
Fig. 4 is a diagram showing the result of a first comparative test;
Fig. 5 is a diagram showing one example of a valve condition corresponding to the nozzle movement condition of Fig. 3 and the target flow-rate condition of Fig. 3;
Fig. 6 is a diagram showing one example of a change in flow rate of a chemical liquid discharged from a nozzle to a plurality of portions of the substrate in a case in which an etching process is executed based on various conditions of Figs. 3 and 5;
Fig. 7 is a diagram showing one example of a change in flow rate of the chemical liquid discharged from the nozzle in a case in which feedback control is executed on an adjustment valve in regard to all of the regions on the substrate based on the target flow-rate condition of Fig. 4;
Fig. 8 is a block diagram showing the outline of configuration of a control system of the substrate processing apparatus of Fig. 1;
Fig. 9 is a block diagram for explaining the one configuration example of functions for executing control based on the nozzle movement condition, the target flow-rate condition, the valve condition and a basic work condition;
Fig. 10 is a flowchart showing a flow of a process executed by the plurality of functions of Fig. 9;
Fig. 11 is a diagram for explaining another example of the target flow-rate condition and the valve condition;
Fig. 12 is a diagram showing the result of a second comparative test;
Fig. 13 is a diagram for explaining yet another example of the valve condition;
Fig. 14 is a schematic plan view showing one example of a substrate processing system including the substrate processing apparatus of Fig. 1; and
Fig. 15 is a schematic diagram showing one example of a liquid supply system according to another embodiment.

### DETAILED DESCRIPTION

A substrate processing apparatus and a substrate processing method according to one embodiment of the present disclosure will be described below with reference to the drawings. In the following description, a substrate refers to a substrate for a Flat Panel Display (FPD) that is used for a liquid crystal display device, an organic Electro Luminescence (EL) display device or the like, a semiconductor substrate, a substrate for an optical disc, a substrate for a magnetic disc, a substrate for a magneto-optical disc, a substrate for a photomask, a ceramic substrate, a substrate for a solar cell or the like.

Further, a substrate, described below, has a circular shape except for a portion in which a notch is formed in plan view. Further, the substrate has a main surface which is a circuit formation surface on which a circuit pattern is formed or a circuit pattern is scheduled to be formed, and a back surface which is the surface opposite to the circuit formation surface. In the following description, regardless of the main surface and the back surface of the substrate, the surface facing upwardly out of two surfaces of the substrate is referred to as an upper surface of the substrate, and the surface facing downwardly out of the two surfaces of the substrate is referred to as a lower surface of the substrate.

Further, the below-mentioned substrate processing apparatus executes a process using a processing liquid on the substrate. During the process, a nozzle that discharges the processing liquid scans above the substrate held and rotated in a horizontal posture. Thus, the processing liquid is supplied to the entire upper surface of the substrate.

### 1. Configuration of Substrate Processing Apparatus

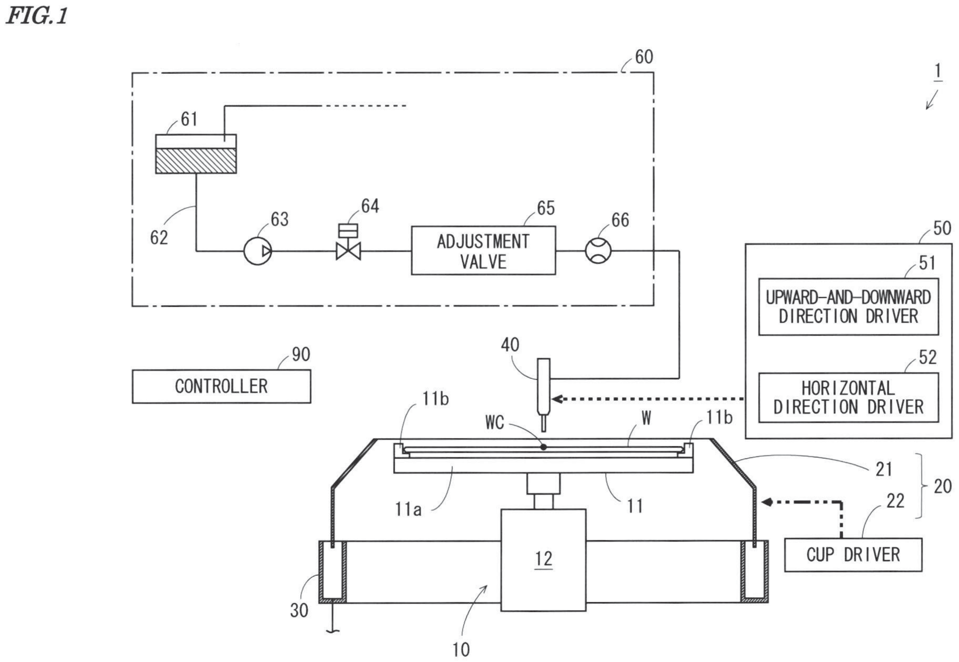

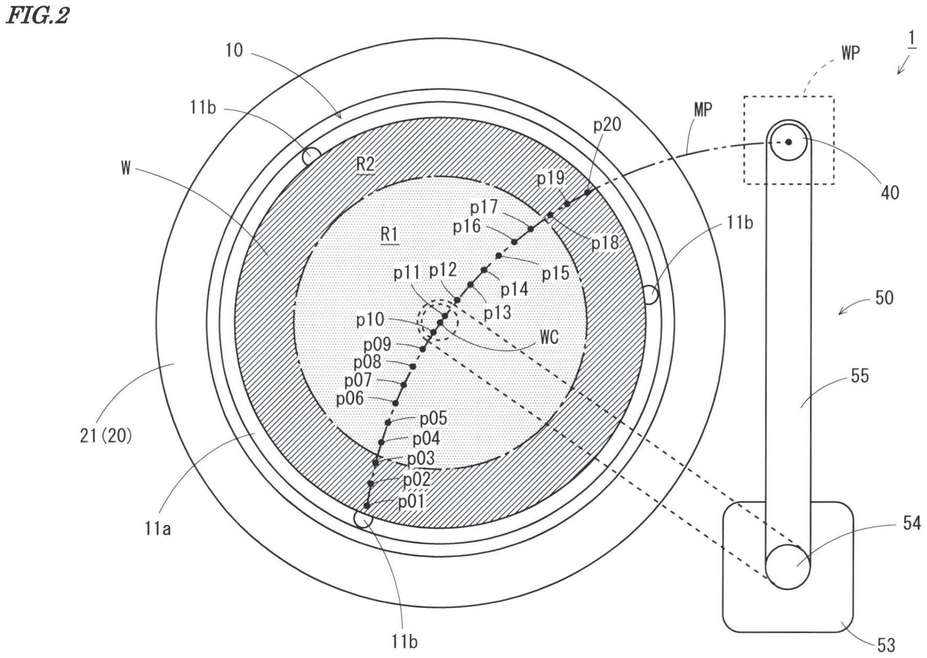

Fig. 1 is a schematic diagram for explaining the configuration of the substrate processing apparatus according to the one embodiment of the present disclosure. Fig. 2 is a schematic plan view of the substrate processing apparatus 1 of Fig. 1. Fig. 2 shows only part of a plurality of constituent elements of the substrate processing apparatus 1 of Fig. 1. Further, the substrate processing apparatus 1 according to the present embodiment includes a substrate holding device 10 that holds the substrate W. Figs. 1 and 2 show the substrate W held by the substrate holding device 10 together with the plurality of constituent elements of the substrate processing apparatus 1.

A film such as a silicon oxide film, a silicon nitride film or a titanium nitride film is formed on the main surface of the substrate W according to the present embodiment. The substrate processing apparatus 1 of Fig. 1 executes an etching process using a chemical liquid on the substrate W as a process for the substrate W using the processing liquid.

As shown in Fig. 1, the substrate processing apparatus 1 includes a cup device 20, a liquid drain device 30, a nozzle 40, a nozzle movement device 50, a liquid supply system 60 and a controller 90, in addition to the above-mentioned substrate holding device 10. At least part of the plurality of constituent elements of Fig. 1 is accommodated in a chamber (not shown). The chamber includes a bottom portion having a rectangular shape, and four sidewall portions extending upwardly from four sides of the bottom portion, for example.

The substrate holding device 10 includes a substrate holder 11 and a rotation driver 12. The rotation driver 12 is a motor, for example, and is fixed to the bottom portion of the chamber, for example. The rotation driver 12 has a rotation shaft extending upwardly. The substrate holder 11 is attached to the upper end of the rotation shaft.

The substrate holder 11 is a so-called mechanical chuck-type spin chuck that holds the outer peripheral end of the substrate W. Specifically, the substrate holder 11 includes a disc-shaped spin base 11a and a plurality of rotary holding pins 11b provided in the peripheral portion of the upper surface of the spin base 11a. In the substrate holder 11, the substrate W is arranged on the spin base 11a with the main surface of the substrate W facing upwardly. At this time, the center WC of the substrate W is positioned on the axial center (central axis) of the rotation shaft of the rotation driver 12. The peripheral portion of the lower surface of the substrate W and the outer peripheral end of the substrate W arranged on the spin base 11a are held by the plurality of holding pins 11b. In this state, the rotation driver 12 works to rotate the substrate W in a horizontal posture.

The chemical liquid is supplied to the upper surface of the substrate W held and rotated by the substrate holding device 10, so that the etching process is executed on the substrate W. The cup device 20 and the liquid drain device 30 are used in order to receive the chemical liquid splashing from the rotating substrate W during the etching process and discharge the chemical liquid to the outside of the substrate processing apparatus 1.

The cup device 20 includes a cup 21 and a cup driver 22. The cup 21 has a substantially cylindrical shape, and is provided to surround the substrate holding device 10 in plan view (Fig. 2) and extend in an upward-and-downward direction. The cup 21 is provided so as to be movable in the upward-and-downward direction. The cup driver 22 includes an actuator such as a motor or an air cylinder. The cup driver 22 moves the cup 21 between a predetermined cup upper position and a predetermined cup lower position according to a supply state of the chemical liquid with respect to the substrate W.

The cup upper position is a height position (position in the upward-and-downward direction) of the cup 21 when the upper end portion of the cup 21 is located above the substrate W held by the substrate holder 11. Thus, with the cup 21 located at the cup upper position, the chemical liquid splashing from the substrate W is received by the cup 21. On the other hand, the cup lower position is the height position of the cup 21 when the upper end portion of the cup 21 is located below the substrate W held by the substrate holder 11. Thus, with the cup 21 located at the cup lower position, it is possible to access the substrate W held by the substrate holder 11 from a position sideward of the substrate holder 11.

The liquid drain device 30 is provided below the cup 21 and includes an annular container corresponding to the cup 21. The container has an annular opening that is directed upwardly, and collects, through the opening, the chemical liquid received by the cup 21. The collected chemical liquid is guided to a drainage facility or a circulation facility in a factory through a pipe, for example.

The nozzle 40 has a discharge port that discharges the chemical liquid. The nozzle 40 is supported by the nozzle movement device 50 with the discharge port of the nozzle 40 being directed downwardly, that is, with the nozzle 40 having a posture with which the chemical liquid can be discharged downwardly. As shown in Fig. 2, the nozzle movement device 50 includes a base portion 53, a support shaft 54 and an arm 55. The base portion 53 is fixed to the bottom portion of the chamber so as to be located outwardly of the cup 21 in plan view. The support shaft 54 is provided so as to extend upwardly from the base portion 53 by a certain distance. The arm 55 extending in a horizontal direction is attached to the upper end portion of the support shaft 54. The nozzle 40 is attached to the tip portion of the arm 55.

As shown in Fig. 1, the nozzle movement device 50 further includes an upward-and-downward direction driver 51 and a horizontal-direction driver 52. Each of the upward-and-downward direction driver 51 and the horizontal-direction driver 52 is built in the base portion 53 of Fig. 2, for example, and includes an actuator such as a motor or an air cylinder.

The upward-and-downward direction driver 51 moves the support shaft 54 in the upward-and-downward direction. Thus, the upward-and-downward direction driver 51 adjusts the height position of the nozzle 40 as necessary. For example, during the etching process for the substrate W, the upward-and-downward direction driver 51 adjusts the height position of the nozzle 40 to a height position higher than the substrate W held by the substrate holder 11.

During the etching process for the substrate W, the horizontal-direction driver 52 rotates the arm 55 about an axis of the support shaft 54. In this case, the nozzle 40 moves so as to draw an arc with the support shaft 54 as a reference in plan view. Thus, the nozzle 40 moves between a position above the substrate W held by the substrate holder 11 and a waiting position WP sideward of the substrate W. In Fig. 2, a path along which the nozzle 40 is movable in plan view is indicated by the two-dots and dash line. In the following description, the path along which the nozzle 40 is movable in plan view is simply referred to as a movement path MP. The movement path MP extends from one portion of the outer peripheral end of the substrate W to another portion of the outer peripheral end of the substrate W through the center WC of the substrate W.

The liquid supply system 60 of Fig. 1 supplies the chemical liquid to the nozzle 40 during the etching process for the substrate W. Examples of the chemical liquid used in the present embodiment include hydrofluoric acid (HF), buffered hydrofluoric acid (BHF), dilute hydrofluoric acid (DHF), a mixture of sulfuric acid and hydrogen peroxide (SPM), a mixture of ammonium water and hydrogen peroxide (SC1), a mixture of hydrochloric acid and hydrogen peroxide (SC2), diluted ammonium hydroxide (dNH₄OH), and tetramethylammonium hydroxide (TMAH).

The type of the chemical liquid to be used is selected according to the type of a film formed on the substrate W, that is, the type of a film to be etched. For example, in a case in which a silicon nitride film is etched, SPM or the like is selected. In a case in which a titanium nitride film is etched, SPM, SC1 or the like is selected. When a silicon oxide film is etched, HF or the like is selected. In a case in which a polysilicon film is etched, SC1, TMAH or the like is selected.

As shown in Fig. 1, the liquid supply system 60 includes a liquid supply source 61, a liquid flow path 62, a pump 63, an open-close valve 64, an adjustment valve 65 and a flow-rate sensor 66. The liquid supply source 61 of the present example is a storage tank, and is configured to be capable of storing a certain amount of the chemical liquid used for the etching process for the substrate W. The liquid flow path 62 is connected to the liquid supply source 61. Therefore, the liquid supply source 61 may include a pipe, a joint and the like for connecting the utility facility of the factory to the liquid flow path 62, instead of the storage tank.

The liquid flow path 62 guides the chemical liquid stored in the liquid supply source 61 to the nozzle 40, and is mainly formed of one or a plurality of pipes. The upstream end of the liquid flow path 62 is connected to the liquid supply source 61. The downstream end of the liquid flow path 62 is connected to the nozzle 40.

In the liquid flow path 62, the pump 63, the open-close valve 64, the adjustment valve 65 and the flow-rate sensor 66 are provided in this order from the upstream end to the downstream end of the liquid flow path 62. The pump 63 sucks the chemical liquid stored in the storage tank of the liquid supply source 61 and pumps the sucked chemical liquid toward the downstream end of the liquid flow path 62.

The open-close valve 64 is a ball valve, for example, allows a flow of the chemical liquid through the liquid flow path 62 when being in an open state, and blocks a flow of the chemical liquid through the liquid flow path 62 when being in a close state. The flow-rate sensor 66 detects an amount of the chemical liquid flowing through the liquid flow path 62 per unit time as a flow rate of the chemical liquid flowing through the liquid flow path 62.

In the present embodiment, the flow rate of the chemical liquid discharged from the nozzle 40 to the substrate W is equal to the flow rate of the processing liquid flowing downstream of the adjustment valve 65 in the liquid flow path 62 of Fig. 1. Therefore, the flow rate detected by the flow-rate sensor 66 according to the present embodiment is equal to the flow rate of the chemical liquid discharged from the nozzle 40.

The adjustment device 65 is a motor needle valve, for example, and is configured to be capable of adjusting a degree of opening (an opening) according to the number of drive pulses provided from the controller 90. The adjustment valve 65 adjusts the flow rate of the chemical liquid flowing through the liquid flow path 62. The work of the adjustment valve 65 is controlled by the controller 90 using a plurality of different methods. Details of the plurality of types of methods of controlling the adjustment valve 65 will be described below.

The controller 90 controls the plurality of constituent elements of the substrate processing apparatus 1 including the adjustment valve 65 such that the etching process is executed on the substrate W. Details of the controller 90 will be described below.

### 2. Basic Work During Etching Process

In the substrate processing apparatus 1 of Fig. 1, the etching process for the substrate W is executed as described above. The etching process of the present example is a process of adjusting the thickness of a film to a thickness according to a predetermined design dimension by dissolving a portion of a film formed on the main surface of the unprocessed substrate W. The etching process for one substrate W is executed as follows, for example. In the initial state, the nozzle 40 is held at the waiting position WP by the nozzle movement device 50.

First, the substrate W carried into the substrate processing apparatus 1 is held by the substrate holder 11. At this time, the center WC of the substrate W is positioned on the axial center of the rotation shaft of the rotation driver 12. Next, the rotation driver 12 works, so that the substrate W is rotated together with the substrate holder 11. Further, the cup driver 22 works, so that the cup 21 is held at the cup upper position.

In this state, the nozzle 40 is moved by the nozzle movement device 50 to a position above the rotating substrate W. Further, the nozzle 40 is positioned at a predetermined start position in a horizontal plane. The start position may overlap with the center WC of the substrate W in plan view, or may overlap with a portion in the vicinity of the outer peripheral end of the substrate W in plan view.

Next, the chemical liquid is supplied from the liquid supply system 60 to the nozzle 40, so that the chemical liquid is discharged from the nozzle 40 to one portion of the substrate W. Further, the nozzle 40 moves back and forth on the substrate W in a certain range of the movement path MP by a predetermined number of repetitions. At this time, the chemical liquid is supplied to a plurality of portions of the main surface of the substrate W, and a film of the substrate W is dissolved. Thus, the thickness of each portion of the film of the substrate W is adjusted.

After the nozzle 40 moves back and forth by the predetermined number of repetitions, the nozzle 40 is positioned at a predetermined end position in a horizontal plane. The end position may overlap with the center WC of the substrate W in plan view, or may overlap with a portion in the vicinity of the outer peripheral end of the substrate W in plan view.

Next, the supply of the chemical liquid from the liquid supply system 60 to the nozzle 40 is stopped. That is, the supply of the chemical liquid to the substrate W is stopped. Further, the nozzle 40 is moved to the waiting position WP by the nozzle movement device 50 and held at the waiting position WP.

Finally, the rotation of the substrate W by the rotation driver 12 is stopped. Further, the cup driver 22 works, so that the cup 21 is lowered from the cup upper position to the cup lower position. Then, the substrate W is carried out from the substrate processing apparatus 1.

The substrate processing apparatus 1 may be provided with a rinse liquid supply device for washing away the chemical liquid supplied onto the substrate W. In this case, in the substrate processing apparatus 1, the chemical liquid adhering to the substrate W can be washed away with a rinse liquid after the etching process. The substrate W that has been cleaned with the rinse liquid may be dried by high-speed rotation (spin drying process).

### 3. Various Conditions Used in Etching Process

### (1) Nozzle Movement Condition and Target Flow-Rate Condition

Suppose that the nozzle 40 moves at a constant speed along the movement path MP on the rotating substrate W. In this case, the area of a region on the substrate W to which the nozzle 40 is opposite per unit time varies depending on a position of the nozzle 40 on the movement path MP because the linear speed of the rotation of the substrate W in the periphery of the substrate W is higher than that in the center of the substrate W. Further, in the rotating substrate W, the temperature of the outer peripheral end of the substrate W and its vicinity is likely to be lower than the temperature of the center WC of the substrate W and its vicinity. Further, depending on the viscosity of the chemical liquid, a difference is generated in regard to the manner of spreading of the chemical liquid on the substrate W according to a rotation speed of a portion of the substrate W to which the chemical liquid is supplied, and an air flow around the portion.

For these reasons, amounts of a film dissolved (processing amounts) by the etching process (processing amount) in the plurality of portions of the rotating substrate W vary depending on the movements speed of the nozzle 40 when the nozzle 40 moves through respective portions and the flow rates of the chemical liquid discharged from the nozzle 40.

Further, the processing amounts required for the plurality of portions of the substrate W are not necessarily equal. For example, on the main surface of the substrate W, a region including the center portion of the substrate W is a region where a circuit pattern is formed or a region where a circuit pattern is to be formed. In the following description, the region of the main surface of the substrate W where a circuit pattern is formed or a circuit pattern is to be formed is referred to as a center region. Further, the region of the main surface of the substrate W including the outer peripheral end of the substrate W and surrounding the center region is referred to as an outer region.

In this case, in regard to the center region of the substrate W, a certain amount or more of the processing liquid is required to be supplied in consideration of the processing amount required for formation of a circuit pattern. On the other hand, a circuit pattern is not formed in the outer region of the substrate W. Therefore, it is fundamentally not necessary to adjust the thickness of a film in the outer region of the substrate W. Therefore, from the viewpoint of reducing the consumption of the chemical liquid, it is preferable that the flow rate of the chemical liquid to be supplied to the outer region of the main surface of the substrate W is reduced as much as possible. Further, due to a reduction of the flow rate of the chemical liquid supplied to the outer region of the main surface of the substrate W, it suppresses collision and splashing of the processing liquid supplied to the outer region of the substrate W with the plurality of holding pins 11b holding the substrate W.

In consideration of these points, in the substrate processing apparatus 1 according to the present embodiment, a nozzle movement condition for dissolving an ideal amount of a film in each of the plurality of portions of the substrate W is defined. The nozzle movement condition includes respective ideal movement speeds of the nozzle 40 when the nozzle 40 moves through the plurality of respective portions of the substrate W as a plurality of partial movement information pieces, and is defined based on simulation or an experiment, for example.

Further, in the substrate processing apparatus 1 according to the present embodiment, a target flow-rate condition for dissolving an ideal amount of a film in the plurality of portions of the substrate W is defined. The target flow-rate condition includes respective ideal flow rates of the processing liquid to be supplied to the plurality of respective portions of the substrate W as a plurality of target flow-rate information pieces, and is defined based on simulation or an experiment, for example. In the following description, the flow rate represented by each of the plurality of target flow-rate information pieces is referred to as a target flow rate.

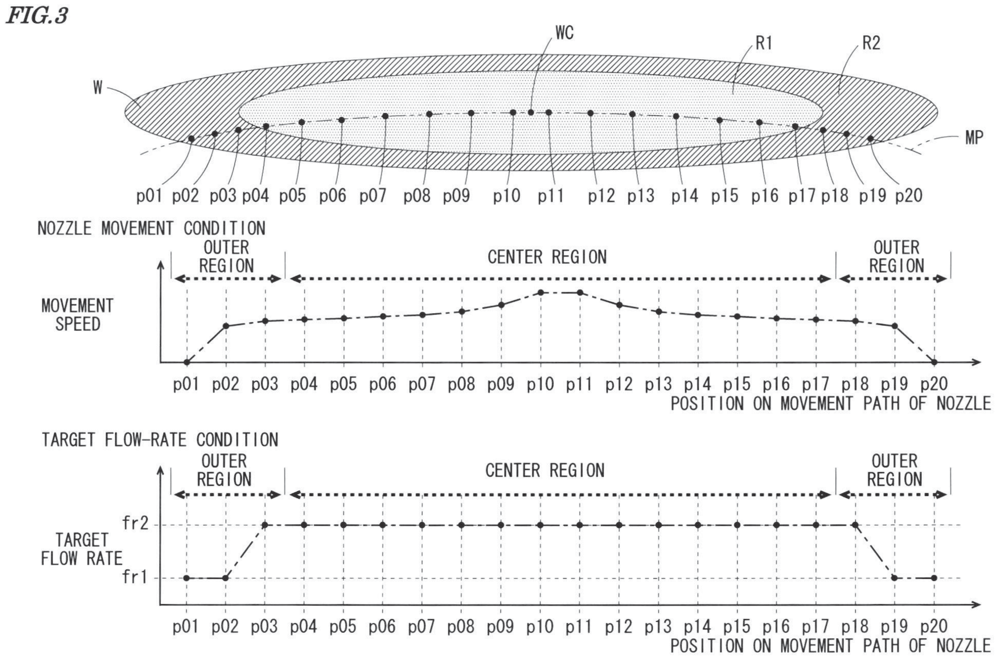

Fig. 3 is a diagram showing one example of the nozzle movement condition and the target flow-rate condition. In the upper field of Fig. 3, an external perspective view of the substrate W is shown. In the substrate W shown in each of Fig. 2 and the upper field of Fig. 3, the dotted pattern is applied to the center region R1 of the upper surface of the substrate W (the main surface of the substrate W in the present example), and the hatching is applied to the outer region R2. In Fig. 3 and subsequent diagrams, in order to facilitate understanding of the relationship between the center region R1 and the outer region R2, the outer region R2 is shown in an exaggerated manner. Further, in the upper field of Fig. 3, a virtual line on the substrate W corresponding to the movement path MP of the nozzle 40 is indicated by the two-dots and dash line. Here, the virtual line is explained as the movement path MP.

In the substrate processing apparatus 1 according to the present embodiment, as shown in each of Fig. 2 and the upper field of Fig. 3, points p01 to p20 indicating a plurality (twenty in the present example) of positions on the movement path MP are defined. When the nozzle 40 moves back and forth on the substrate W, because the nozzle 40 passes through the points p01 to p20, the discharge port of the nozzle 40 is opposite to the plurality of portions of the substrate W. As such, in the following description, the points p01 to p20 are explained as the plurality of portions on the substrate W.

The point p01 is located in the vicinity of one portion of the outer peripheral end of the substrate W in plan view. The point p20 is located in the vicinity of another portion of the outer peripheral end of the substrate W in plan view. The points p02, p03, p04, p05, p06, p07, p08, p09, p10, p11, p12, p13, p14, p15, p16, p17, p18, p19 are located between the point p01 and the point p20, and are arranged in this order from the point p01 toward the point p20 at substantially equal intervals. The point p10 and the point p11 are adjacent to each other with the center WC of the substrate W located therebetween. Further, the points p04 to p17 of the present example are located in the center region R1 of the substrate W, and the points p01 to p03, p18 to p20 are located in the outer region R2 of the substrate W.

In the middle field of Fig. 3, one example of the nozzle movement condition is shown by a graph. In the graph of the nozzle movement condition, the ordinate indicates a movement speed of the nozzle 40, and the abscissa indicates a position on the movement path MP. In the nozzle movement condition of the present example, the movement speed of the nozzle 40 when the nozzle 40 moves through each of the points p01 to p20 is defined. According to the nozzle movement condition, the movement speeds for the points p01, p20 are zero. On the other hand, the movement speeds for the points p02 to p19 are set to relatively high movement speeds. These movement speeds are about 150 m/sec to 600 m/sec, for example. Note that, among the points p12 to p19, the movement speeds for the points p10, p11 located in the vicinity of the center WC of the substrate W are higher than the movement speeds for the other points p02 to p09, p12 to p17.

In the nozzle movement condition of the present example, the movement speeds for the center WC of the substrate W and its vicinity are basically high, and the movement speeds in the vicinity of the outer peripheral end of the substrate W are basically low. This nozzle movement condition is mainly defined in consideration of the temperature distribution of the rotating substrate W in order to make the etching rate of the entire upper surface of the substrate W be uniform.

In the lower field of Fig. 3, one example of the target flow-rate condition is shown by a graph. In the graph of the target flow-rate condition, the ordinate indicates a target flow rate, and the abscissa indicates a position on the movement path MP. In the target flow-rate condition of the present example, the target flow rates of the chemical liquid to flow through the liquid flow path 62 when the nozzle 40 moves through the points p01 to p20 are defined. In other words, a plurality of target flow rates of the chemical liquid to be discharged from the nozzle 40 when the nozzle 40 moves through the points p01 to p20 are defined. According to the target flow-rate condition, the target flow rates for the points p01, p02, p19, p20 are set to a first flow-rate fr1. On the other hand, the target flow rates for the points p03 to p18 are set to a second flow rate fr2 higher than the first flow rate fr1. The difference between the first flow rate fr1 and the second flow rate fr2 is relatively large. The first flow fate fr1 is 400 ml/min, for example, and the second flow rate fr2 is 2000 ml/min, for example.

In the target flow-rate condition of the present example, the target flow rate for the center region R1 of the substrate W is basically high, and the target flow rate for the outer region R2 of the substrate W is basically low. As described above, this target flow-rate condition is defined for the purpose of supplying a sufficient amount of the chemical liquid for formation of a circuit pattern in the center region R1 and reducing the consumption of the chemical liquid in the outer region R2.

The horizontal-direction driver 52 of Fig. 1 includes a motor having a built-in encoder. Further, the controller 90 of Fig. 1 detects a current rotation angle of the motor based on an output signal of the encoder of the horizontal-direction driver 52. Further, based on the detection result of a rotation angle of the motor, the controller 90 acquires a current position of the nozzle 40 on the movement path MP (a position on the upper surface of the substrate W).

Thus, based on the current position of the nozzle 40 and the nozzle movement condition, the controller 90 controls the horizontal-direction driver 52. Therefore, the controller 90 adjusts the movement speed of the nozzle 40 when the nozzle 40 moves through each portion of the substrate W to an ideal speed. Further, based on the current position of the nozzle 40 and the target flow-rate condition, the controller 90 controls the liquid supply system 60. Thus, the controller 90 adjusts the flow rate of the chemical liquid supplied to each portion on the substrate W to a target flow rate.

### (2) Valve Condition

The flow rate of the chemical liquid discharged from the nozzle 40 is adjusted by control for the adjustment valve 65 of Fig. 1. Further, as described above, the work of the adjustment valve 65 according to the present embodiment is controlled by the controller 90 using a plurality of types of methods.

One of the plurality of types of control for the adjustment valve 65 is feedback control for adjusting an opening of the adjustment valve 65, based on a detection result of the flow-rate sensor 66, such that the flow rate of the chemical liquid flowing through the liquid flow path 62 is brought close to the target flow rate for the current position of the nozzle 40. Further, another one of the plurality of types of control for the adjustment valve 65 is control for adjusting an opening of the adjustment valve 65 to a predetermined prescribed opening regardless of a detection result of the flow-rate sensor 66. In the following description, the control for adjusting an opening of the adjustment valve 65 to the prescribed opening is referred to as fixed control.

In the present embodiment, the prescribed opening is set to an opening corresponding to the target flow rate. For example, in a case in which the target flow rate for one portion (the point p02 on the movement path MP, for example) on the substrate W is the first flow rate fr1, the prescribed opening for the portion is set to an opening of the adjustment valve 65 at which the flow rate of the chemical liquid discharged from the nozzle 40 is estimated to be the first flow rate fr1. Further, in a case in which the target flow rate for another portion (the point p04 on the movement path MP, for example) on the substrate W is the second flow rate fr2, the prescribed opening for the portion is set to the opening of the adjustment valve 65 at which the flow rate of the chemical liquid discharged from the nozzle 40 is estimated to be the second flow rate fr2.

Here, the feedback control is the control for sequentially changing the adjustment amount of the opening of the adjustment valve 65 according to a detection result of the flow-rate sensor 66. Therefore, in a case in which the flow rate of the chemical liquid is changed by the feedback control for the adjustment valve 65, it is considered that a relatively large response delay is likely to occur in regard to a change in flow rate of the chemical liquid actually discharged from the nozzle 40. On the other hand, in a case in which the flow rate of the chemical liquid is changed by the fixed control for the adjustment valve 65, it is considered that a large response delay is unlikely to occur in regard to a change in flow rate of the chemical liquid actually discharged from the nozzle 40.

The inventors of present disclosure performed a first comparative test described below using the substrate processing apparatus 1 of Fig. 1 in order to compare a change in flow rate of the chemical liquid caused by the feedback control and a change in flow rate of the chemical liquid caused by the fixed control.

First, the inventors of the present disclosure caused the pump 63 to work, put the open-close valve 64 in an open state, and adjusted an opening of the adjustment valve 65 such that the detection result of the flow-rate sensor 66 was about 250 ml/min. Thereafter, the inventors of the present disclosure executed the feedback control on the adjustment valve 65 to increase the flow rate of the chemical liquid flowing downstream of the adjustment valve 65 from about 250 ml/min to 2000 ml/min. The inventors of the present disclosure also recorded the detection result of the flow-rate sensor 66 then.

Subsequently, the inventors of the present disclosure re-adjusted the opening of the adjustment valve 65 such that the detection result of the flow-rate sensor 66 was about 250 ml/min. Thereafter, the inventors of the present executed the fixed control on the adjustment valve 65 to increase the flow rate of the chemical liquid flowing downstream of the adjustment valve 65 from about 250 ml/min to 2000 ml/min. The inventors of the present disclosure also recorded the detection result of the flow-rate sensor 66 then.

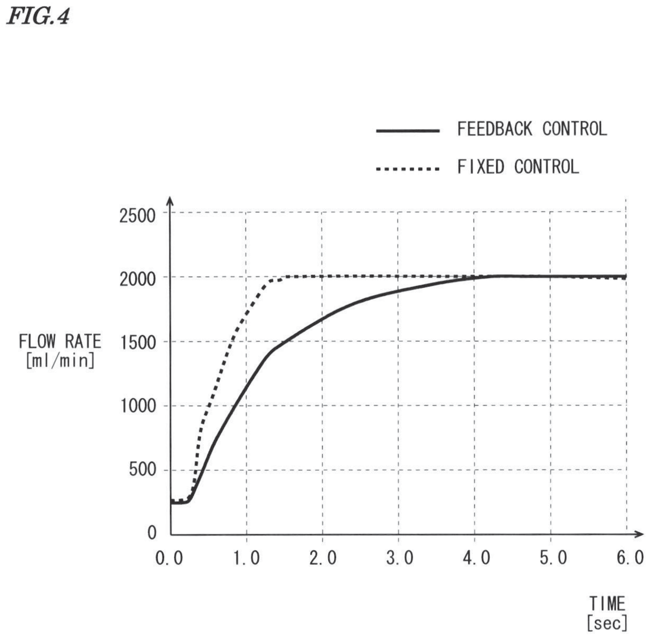

Fig. 4 is a diagram showing the result of the first comparative test. In Fig. 4, the ordinate indicates the flow rate of the chemical liquid flowing downstream of the adjustment valve 65, and the abscissa indicates the time. Further, in Fig. 4, the change in flow rate of the chemical liquid when the flow rate of the chemical liquid discharged from the nozzle 40 is increased from about 250 ml/min to 2000 ml/min by the feedback control is indicated by the thick solid line. On the other hand, the flow rate of the chemical liquid discharged from the nozzle 40 when the flow rate of the chemical liquid discharged from the nozzle 40 is increased from about 250 ml/min to 2000 ml/min by the fixed control is indicated by the thick dotted line.

As shown in Fig. 4, with the feedback control, it requires about 4 seconds to increase the flow rate of the chemical liquid from about 250 ml/min to 2000 ml/min. In contrast, with the fixed control, it takes about 1. 5 seconds to increase the flow rate of the chemical liquid from about 250 ml/min to 2000 ml/min.

As is apparent from this result, the fixed control for the adjustment valve 65 enhances the responsiveness of the flow-rate adjustment of the chemical liquid as compared with the feedback control of the adjustment valve 65. Further, it is considered that the larger the flow-rate change amount of the chemical liquid, the larger the difference between the responsiveness of such two control methods. When a sufficient amount of the chemical liquid is not supplied to the center region R1 due to the low responsiveness of the flow-rate adjustment of the chemical liquid, a processing defect of the substrate W may occur. Further, when the flow rate of the chemical liquid supplied to the outer region R2 cannot be sufficiently reduced, it cannot suppress wasteful consumption of the chemical liquid.

As such, in the substrate processing apparatus 1 according to the present embodiment, a valve condition representing a method of controlling the adjustment valve 65 when the nozzle 40 moves through each of the plurality of portions of the substrate W is further defined.

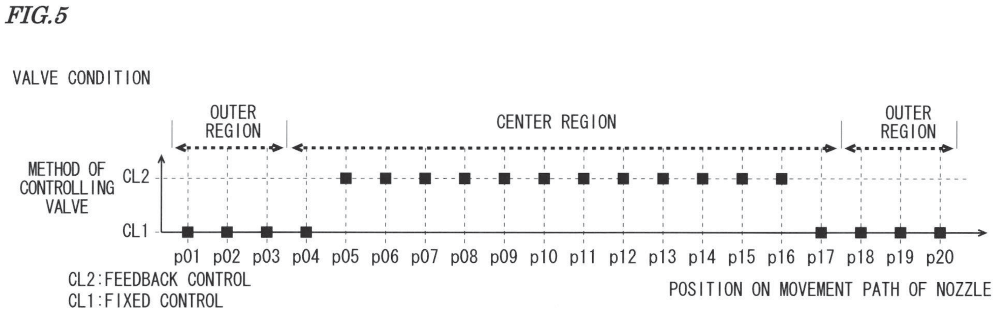

Fig. 5 is a diagram showing one example of the valve condition corresponding to the nozzle movement conditions of Fig. 3 and the target flow-rate condition of Fig. 3. In the graph of the valve condition of Fig. 5, the ordinate indicates a method of controlling the valve, and the abscissa indicates a position on the movement path MP. On the ordinate, a reference sign CL1 is denoted as the fixed control, and a reference sign CL2 is denoted as the feedback control.

In the valve condition of the present example, a plurality of control methods to be executed when the nozzle 40 moves through the respective points p01 to p20 are defined. According to the valve condition, it is defined that the fixed control for the adjustment valve 65 is to be executed at the points p01 to p04, p17 to p20. The points p01 to p04, p17 to p20 are located in the outer region R2 where the target flow rates are low and the flow rates are not required to be adjusted with high accuracy, and in a region on the substrate W where the target flow rates largely vary. Further, according to the valve condition, it is defined that the feedback control for the adjustment valve 65 is to be executed at the points p05 to p16. The points p05 to p16 are located in the center region R1 where the target flow rates are high and do not vary.

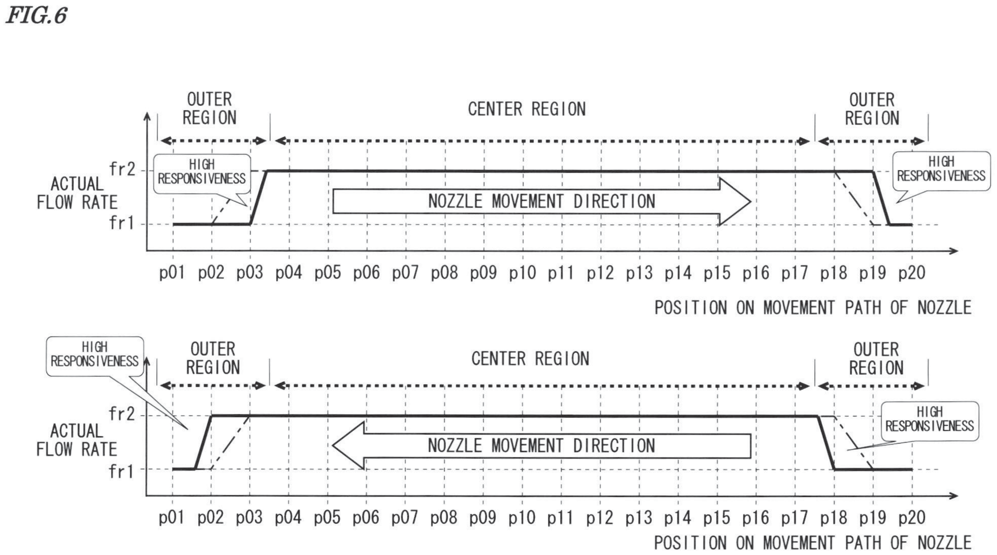

Fig. 6 is a diagram showing one example of the flow-rate change of the chemical liquid discharged from the nozzle 40 in the plurality of portions of the substrate W in a case in which the etching process is executed based on the various conditions of Figs. 3 and 5. In Fig. 6, in the upper field of the graph, the flow-rate change of the chemical liquid when the nozzle 40 moves from the point p01 toward the point p20 is shown. Further, in the lower field of the graph, the flow-rate change of the chemical liquid when the nozzle 40 moves from the point p20 toward the point p01 is shown.

In the graphs in the upper and lower fields of Fig. 6, the ordinate indicates a flow rate of the chemical liquid discharged from the nozzle 40, and the abscissa indicates a position on the movement path MP. Further, the flow-rate change of the chemical liquid discharged from the nozzle 40 is indicated by the thick solid line, and the ideal flow-rate change of the chemical liquid according to the target flow-rate condition is indicated by the one-dot and dash line.

As shown in the upper field of Fig. 6, suppose that the nozzle 40 moves from the point p01 toward the point p20. In this case, the controller 90 executes the fixed control for the adjustment valve 65 such that the flow rate of the chemical liquid for each of the points p01, p02 is the first flow rate fr1 according to the target flow-rate condition of Fig. 3, for example. Thereafter, when the nozzle 40 reaches the point p03, the controller 90 determines, according to the target flow-rate condition of Fig. 3, that the flow rate of the chemical liquid to be supplied to the nozzle 40 at a current point in time is the second flow rate fr2. As such, the controller 90 executes the fixed control for the adjustment valve 65 such that the flow rate of the chemical liquid changes from the first flow rate fr1 to the second flow rate fr2. As described above, the fixed control enhances the responsiveness of the flow-rate adjustment of the chemical liquid. Thus, the flow rate of the chemical liquid discharged from the nozzle 40 is brought close to the target flow rate before the nozzle 40 enters the center region R1.

Further, the controller 90 executes the fixed control for the adjustment valve 65 such that the flow rate of the chemical liquid is the second flow rate fr2 for the point p18 according to the target flow-rate condition of Fig. 3, for example. Thereafter, when the nozzle 40 reaches the point p19, the controller 90 determines, according to the target flow-rate condition of Fig. 3, that the flow rate of the chemical liquid to be supplied to the nozzle 40 at a current point in time is the first flow rate fr1. As such, the controller 90 executes the fixed control for the adjustment valve 65 such that the flow rate of the chemical liquid changes from the second flow rate fr2 to the first flow rate fr1. As described above, the fixed control enhances the responsiveness of the flow-rate adjustment of the chemical liquid. Thus, the flow rate of the chemical liquid discharged from the nozzle 40 is brought close to the target flow rate before the nozzle 40 reaches the point p20.

As shown in the lower field of Fig. 6, suppose that the nozzle 40 moves from the point p20 toward the point p01. Also in this case, when the target flow rate changes between the first flow rate fr1 and the second flow rate fr2 in the outer region R2 of the substrate W, the fixed control for the adjustment valve 65 is executed. Thus, the flow rate of the chemical liquid discharged from the nozzle 40 is brought close to the target flow rate with high responsiveness.

As a result, according to the valve condition of Fig. 5, non-supply of a sufficient amount of the chemical liquid to the center region R1 of the substrate W due to low responsiveness of the flow-rate adjustment of the chemical liquid is suppressed. Further, in the outer region R2 of the substrate W, the consumption of the chemical liquid can be sufficiently reduced.

In a large portion of the center region R1 of the substrate W, the feedback control for the adjustment valve 65 is executed. Thus, the flow rate of the chemical liquid discharged from the nozzle 40 to the substrate W is adjusted with high accuracy.

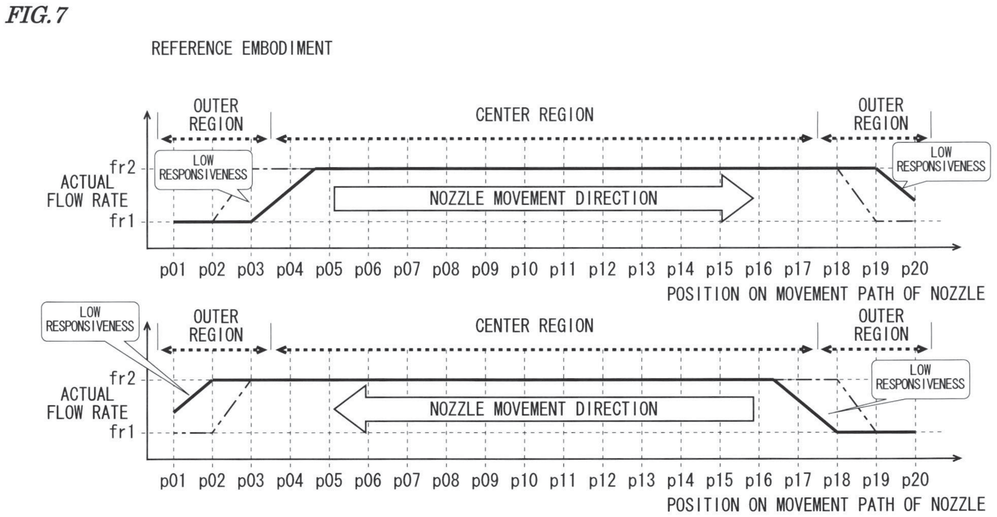

Here, in a reference embodiment, the feedback control for the adjustment valve 65 is always executed during the etching process for the substrate W, by way of example. Fig. 7 is a diagram showing one example of the flow-rate change of the chemical liquid discharged from the nozzle 40 in a case in which the feedback control for the adjustment valve 65 is executed in all regions on the substrate W based on the target flow-rate condition of Fig. 4.

In the present reference embodiment, all of methods of controlling the adjustment valve 65 to be executed when the nozzle 40 moves through each of the points p01 to p20 are the feedback control.

In Fig. 7, in each of the upper and lower fields, one example of the flow-rate change of the chemical liquid discharged from the nozzle 40 due to the feedback control for the adjustment valve 65 is shown. The graph in the upper field shows the flow-rate change of the chemical liquid when the nozzle 40 moves from the point p01 toward the point p20. Further, the graph in the lower field shows the flow-rate change of the chemical liquid when the nozzle 40 moves from the point p20 toward the point p01.

In a case in which the flow rate of the chemical liquid is changed by the feedback control for the adjustment valve 65, a relatively large response delay is likely to occur in regard to the flow-rate change of the chemical liquid actually discharged from the nozzle 40. In the present example, as shown in the upper and lower fields of Fig. 7, a period of time required to change the flow rate of the chemical liquid between the first flow rate fr1 and the second flow rate fr2 is increased.

In this case, when the nozzle 40 moves above the center region R1 of the substrate W, the flow rate of the chemical liquid discharged from the nozzle 40 is highly likely not to reach the target flow rate (the second flow rate fr2, for example). The shortage of the flow rate of the chemical liquid supplied to the center region R1 causes a processing defect of the substrate W.

Further, in the outer region R2 of the substrate W, the flow rate of the chemical liquid discharged from the nozzle 40 is more likely not to reach the target flow rate (the first flow rate fr1, for example). When an excessive amount of the chemical liquid is supplied to the outer region R2, the chemical liquid is wastefully consumed. Further, the supply of an excessive amount of the chemical liquid to the outer region R2 causes splashing of an extra chemical liquid in the vicinity of the outer peripheral end of the substrate W.

### (3) Basic Work Condition

As described above, when the etching process for the substrate W is started, the nozzle 40 is positioned at the predetermined start position on the substrate W. Further, during the etching process for the substrate W, the nozzle 40 moves back and forth on the substrate W by a predetermined number of repetitions. Further, when the etching process for the substrate W ends, the nozzle 40 is positioned at the predetermined end position on the substrate W.

In the substrate processing apparatus 1 according to the present embodiment, a plurality of information pieces representing the start position of the nozzle 40, the number of repetitions of the reciprocating movement, the end position of the nozzle 40, and the like are further defined as the basic work conditions of the etching process.

The nozzle movement condition, the target flow-rate condition, the valve condition and the basic work condition, described above, are stored in the controller 90 in advance before the etching process for the substrate W. Thus, the controller 90 executes the etching process based on the nozzle movement condition, the target flow-rate condition, the valve condition and the basic work condition.

### 4. Control System of Substrate Processing Apparatus 1

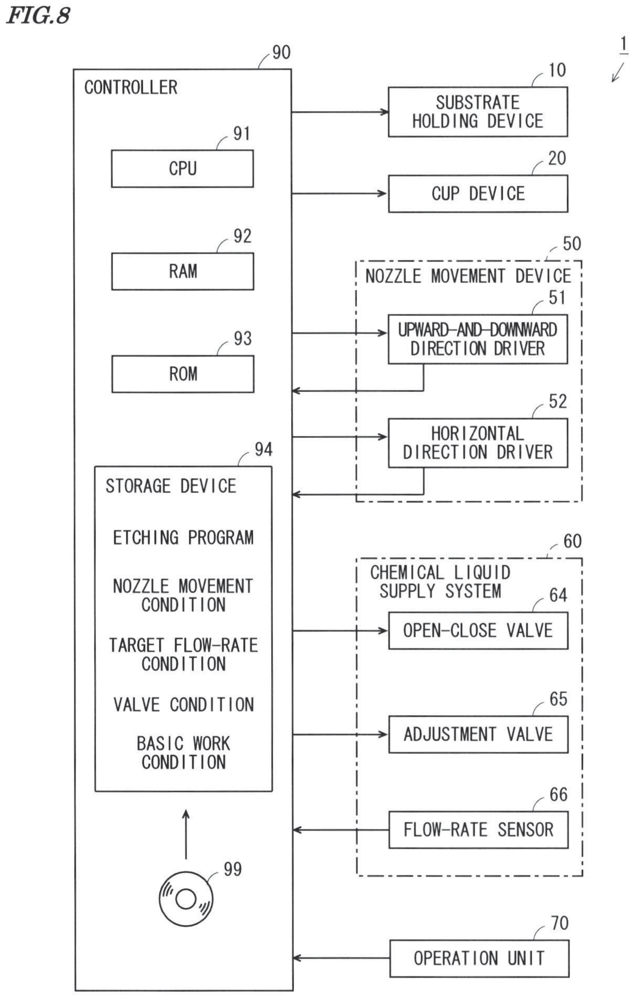

A control system of the substrate processing apparatus 1 will be described together with the configuration of the controller 90 of Fig. 1. Fig. 8 is a block diagram showing the outline of the configuration of the control system of the substrate processing apparatus 1 of Fig. 1. As shown in Fig. 8, the controller 90 includes a Central Processing Unit (CPU) 91, a Random Access Memory (RAM) 92, a Read Only Memory (ROM) 93 and a storage device 94. The RAM 92 is used as a work area for the CPU 91. A system program is stored in the ROM 93. The storage device 94 includes a storage medium such as a hard disc or a semiconductor memory, and stores an etching program for executing the above-mentioned etching process on the substrate W.

The etching program may be provided in the state of being stored in a recording medium such as a CD-ROM 99 and installed in the ROM 903 or the storage device 94. Alternatively, the etching program may be distributed from a server outside of the substrate processing apparatus 1 through a communication network, and installed in the ROM 903 or the storage device 94.

The CPU 91 executes the etching program to control the work of each constituent element of the substrate processing apparatus 1. Specifically, the controller 90 controls the substrate holding device 10. Thus, the controller 90 causes the substrate holding device 10 to hold the substrate W carried into the substrate processing apparatus 1. Further, the controller 90 releases the holding state of the substrate W held by the substrate holding device 10 in order to carry the substrate W out of the substrate processing apparatus 1. Further, the controller 90 rotates the substrate W held by the substrate holding device 10 at a preset speed.

Further, the controller 90 controls the cup device 20. Thus, the controller 90 moves the cup 21 of Fig. 1 between the cup upper position and the cup lower position. Further. the controller 90 controls the upward-and-downward direction driver 51 and the horizontal-direction driver 52 of the nozzle movement device 50. Thus, the controller 90 moves the nozzle 40 between a position above the substrate W and the waiting position WP. Further, the controller 90 moves the nozzle 40 along the movement path MP while being above the substrate W.

Further, as described above, the controller 90 acquires a current position of the nozzle 40 based on output signals of the encoders of the upward-and-downward direction driver 51 and the horizontal-direction driver 52 when the nozzle movement device 50 moves the nozzle 40.

Further, the controller 90 controls the open-close valve 64 and the adjustment valve 65 of the liquid supply system 60. Thus, the controller 90 supplies the chemical liquid to the nozzle 40 during the etching process. Further, the controller 90 acquires a detection result provided by the flow-rate sensor 66.

The substrate processing apparatus 1 further includes an operation unit 70. The operation unit 70 includes a keyboard and a pointing device, for example, and is configured to be operable by a user. The user can input the nozzle movement condition, the target flow-rate condition, the valve condition and the basic work condition by operating the operation unit 70. The respective input conditions are stored in the storage device 94 of the controller 90.

### 5. Configuration Example of Plurality of Functions in Controller 90

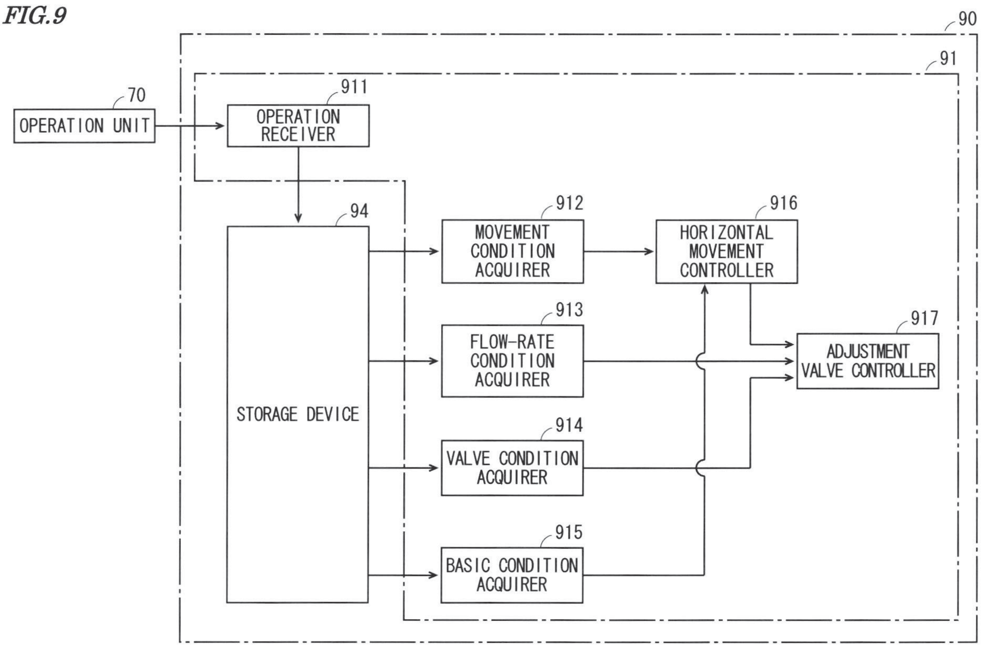

Fig. 9 is a block diagram for explaining the one configuration example of the functions for executing control based on the nozzle movement condition, the target flow-rate condition, the valve condition and the basic work condition. As shown in Fig. 9, the CPU 91 of the controller 90 includes, as the functions for executing control based on various conditions, an operation receiver 911, a movement condition acquirer 912, a flow-rate condition acquirer 913, a valve condition acquirer 914, a basic condition acquirer 915, a horizontal movement controller 916 and an adjustment valve controller 917. These functions are implemented by execution, by the CPU 91 of the controller 90, of the etching program stored in the storage device 94. Part or all of the above-mentioned functions may be realized by hardware such as an electronic circuit.

The operation receiver 911 receives the nozzle movement condition, the target flow-rate condition, the valve condition and the basic work condition received from the operation unit 70 of Fig. 8. Further, the operation receiver 911 stores the respective received conditions in the storage device 94.

In a case in which the etching process is executed on the substrate W, the movement condition acquirer 912 acquires the nozzle movement condition stored in the storage device 94. Further, the movement condition acquirer 912 provides the acquired nozzle movement condition to the horizontal movement controller 916.

In a case in which the etching process is executed on the substrate W, the flow-rate condition acquirer 913 acquires the target flow-rate condition stored in the storage device 94. Further, the flow-rate condition acquirer 913 provides the acquired target flow-rate condition to the adjustment valve controller 917.

In a case in which the etching process is executed on the substrate W, the valve condition acquirer 914 acquires the valve condition stored in the storage device 94. Further, the valve condition acquirer 914 provides the acquired valve condition to the adjustment valve controller 917.

In a case in which the etching process is executed on the substrate W, the basic condition acquirer 915 acquires the basic work condition stored in the storage device 94. Further, the basic condition acquirer 915 provides the acquired basic work condition to the horizontal movement controller 916.

When the etching process for the substrate W is started, the horizontal movement controller 916 controls the horizontal-direction driver 52 of Fig. 8 based on the nozzle movement condition and the basic work condition provided by the movement condition acquirer 912 and the basic condition acquirer 915.

Further, the horizontal movement controller 916 detects a current position of the nozzle 40 on the movement path MP based on an output signal of the encoder of the horizontal-direction driver 52. Further, the horizontal movement controller 916 provides the detected current position of the nozzle 40 on the movement path MP to the adjustment valve controller 917.

The horizontal-direction driver 52 may include a pulse motor instead of a motor having a built-in encoder. In this case, the horizontal movement controller 916 controls the rotation angle of the pulse motor by providing one or a plurality of drive pulses to the horizontal-direction driver 52. As such, the horizontal movement controller 916 detects a rotation angle of the pulse motor by counting the number of drive pulses provided to the horizontal-direction driver 52. Further, the horizontal movement controller 916 detects the current position of the nozzle 40 on the movement path MP based on the rotation angle of the pulse motor.

During the etching process for the substrate W, the adjustment valve controller 917 controls the liquid supply system 60 of Fig. 8 based on the target flow-rate condition, the valve condition and the current position of the nozzle 40. Thus, the adjustment valve 65 is controlled by the control method according to the current position of the nozzle 40, and the chemical liquid is discharged from the nozzle 40 at a flow rate that coincides or substantially coincides with the target flow rate.

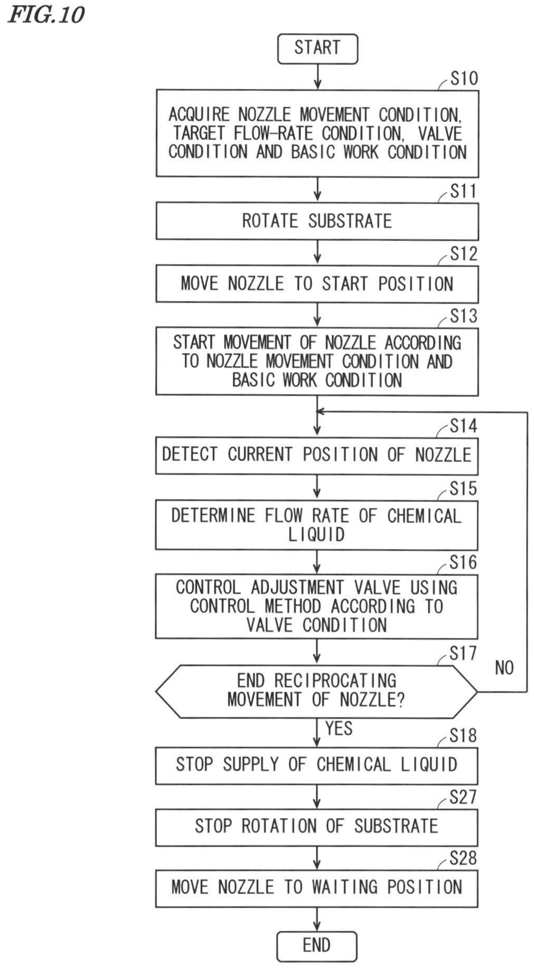

Fig. 10 is a flowchart showing a flow of process executed by the plurality of functions of Fig. 9. In Fig. 10, in order to mainly show the process executed by the plurality of functions of Fig. 9, description in regard to the movement of the nozzle 40 in the upward-and-downward direction and the movement of the cup 21 in the upward-and-downward direction is not made.

The etching process for the substrate W is started at a predetermined point in time by execution of the etching program in the controller 90. In an initial state, suppose that the nozzle movement condition, the target flow-rate condition, the valve condition and the basic work condition are stored in advance in the storage device 94. Further, suppose that the substrate W to be processed is held by the substrate holder 11. Further, suppose that the nozzle 40 is held at the waiting position WP.

When the etching process for the substrate W is started, the plurality of acquirers (912, 913, 914, 915) of Fig. 9 acquire the nozzle movement condition, the target flow-rate condition, the valve condition and the basic work condition from the storage device 94 (step S10). Next, the CPU 91 of the controller 90 controls the rotation driver 12 of the substrate holding device 10 to rotate the substrate W at a predetermined speed (step S11).

Next, the horizontal movement controller 916 controls the horizontal-direction driver 52 based on the basic work condition to move the nozzle 40 to the start position (step S12). When the nozzle 40 reaches the start position, the horizontal movement controller 916 starts the movement of the nozzle 40 according to the acquired nozzle movement condition and the acquired basic work condition (step S13).

Subsequently, the horizontal movement controller 916 detects a current position of the nozzle 40 on the movement path MP based on an output signal of the encoder of the horizontal-direction driver 52 or the counted number of drive pulses provided to the horizontal-direction driver 52 (step S14).

Next, the adjustment valve controller 917 determines the flow rate of the chemical liquid to be supplied to the nozzle 40 at a current point in time based on the target flow-rate condition and the current position of the nozzle 40 (step S15).

Next, the adjustment valve controller 917 controls the adjustment valve 65 by a control method according to the valve condition such that the chemical liquid is supplied to the nozzle 40 at the determined flow rate (step S16). Thereafter, the adjustment valve controller 917 determines whether to end the reciprocating movement of the nozzle 40 (step S17). Specifically, based on the basic work condition and the path along which the nozzle 40 has actually moved after the process of the step S13, the adjustment valve controller 917 determines whether the nozzle 40 has completed the reciprocating movement by the predetermined number of repetitions and is located at the end position.

In a case in which the reciprocating movement of the nozzle 40 has not ended, the process returns to the step S14. On the other hand, in a case in which the reciprocating movement of the nozzle 40 has ended, the adjustment valve controller 917 controls the open-close valve 64 to stop the supply of the chemical liquid to the nozzle 40 (step S18).

Finally, the CPU 91 of the controller 90 controls the rotation driver 12 of the substrate holding device 10 to stop the rotation of the substrate W (step S27), and moves the nozzle 40 to the waiting position WP (step S28). Thus, the etching process for the substrate W ends.

### 6. Effects

In the following description, two portions arranged adjacent to each other in a radial direction of the substrate W in the outer region R2 of the substrate W are referred to as a first portion and a second portion. The first portion is closer to the center region R1 than the second portion. Specifically, the first portion corresponds to each of the points p03, p18 on the movement path MP of Fig. 2. The second portion corresponds to each of the points p02, p19 on the movement path MP of Fig. 2.

In the target flow-rate condition set in the above-mentioned substrate processing apparatus 1, the target flow rates corresponding to the center region R1 and the first portion in the outer region R2 of the substrate W are higher than the target flow rate corresponding to the second portion in the outer region R2 of the substrate W. Further, when the nozzle 40 moves through at least one portion in the center region R1 of the substrate W, the feedback control for the adjustment valve 65 is executed. Thus, an amount of the chemical liquid required for the etching process is likely to be supplied to the center region R1 of the substrate W with high accuracy. Therefore, the etching process is executed on the center region R1 of the substrate W with high accuracy.

On the other hand, when the nozzle 40 moves through the outer region R2 of the substrate W, the fixed control for the adjustment valve 65 is executed. In this case, because the target flow rate corresponding to the second portion of the substrate W is lower than the target flow rates corresponding to the center region R1 and the first portion of the substrate W, an amount of the processing liquid supplied to the outer region R2 of the substrate W is reduced by setting of the adjustment valve 65 to a prescribed opening. In other words, an excessive amount of the chemical liquid is prevented from being supplied to a region in the substrate W in which a circuit pattern is not formed.

Further, the fixed control enhances the responsiveness of the flow-rate change of the chemical liquid flowing through the liquid flow path 62 as compared with the feedback control. Therefore, when the nozzle 40 continuously moves through the first portion and the second portion, a large response delay is unlikely to occur in regard to the flow rate of the chemical liquid supplied to the substrate W. As a result, it suppresses a large deviation of the flow rate of the chemical liquid supplied to the center region R1 of the substrate W from a target flow rate. Further, in the outer region R2 of the substrate W, wasteful consumption of the chemical liquid is suppressed. As a result, it is possible to execute a process on the substrate W with high accuracy while suppressing wasteful consumption of the chemical liquid.

In regard to the outer region R2 of the substrate W, it is not necessary to accurately match an amount of the chemical liquid supplied to the substrate W with a target flow rate. This is because the outer region R2 of the substrate W is a region in which a circuit pattern is not formed, and it is not necessary to strictly manage the supply flow rate of the chemical liquid.

### 7. Another Example of Valve Condition

As described above, the feedback control for the adjustment valve 65 can enhance the accuracy of the flow-rate adjustment of the chemical liquid. On the other hand, the fixed control for the adjustment valve 65 can enhance the responsiveness of the flow-rate adjustment of the chemical liquid. In consideration of these points, the valve condition may be defined such that the fixed control is executed on the adjustment valve 65 in regard to a portion of the movement path MP where the target flow rate largely changes by a predetermined threshold flow rate or more, and may be defined such that the feedback control is executed on the adjustment valve 65 in regard to the other portions of the movement path MP.

The above-mentioned threshold flow rate is set to a value (about 400 ml/min, for example) at which the responsiveness of the flow-rate adjustment in a case in which the feedback control is executed on the adjustment valve 65 is not significantly reduced.

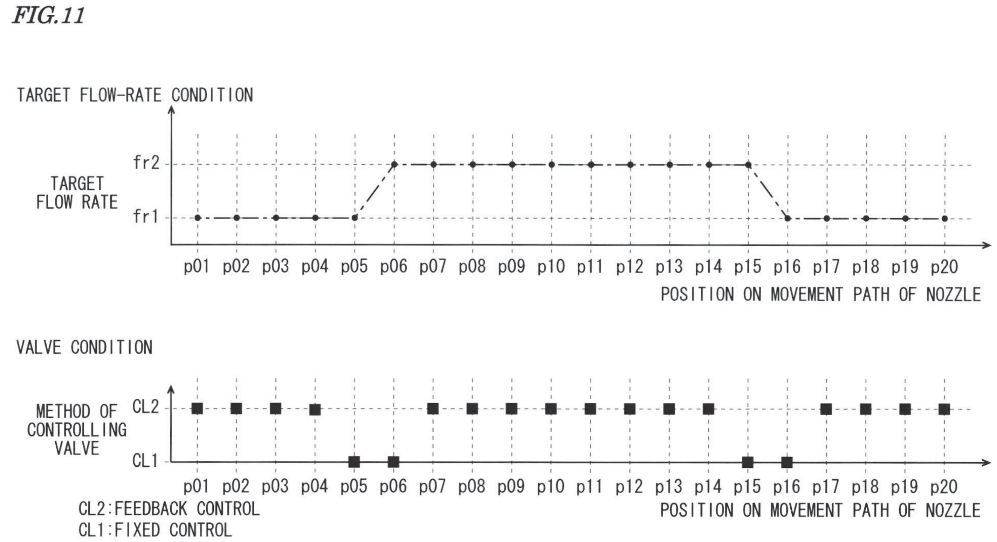

Fig. 11 is a diagram for explaining another example of the target flow-rate condition and the valve condition. In the upper field of Fig. 11, another example of the target flow-rate condition is shown by a graph. In the graph of the target flow-rate condition, the ordinate indicates a target flow rate, and the abscissa indicates a position on the movement path MP. According to the target flow-rate condition, the target flow rates for the points p01 to p05, p16 to p20 are set to the first flow rate fr1. On the other hand, the target flow rates for the points p06 to p15 are set to the second flow rate fr2 higher than the first flow rate fr1. The difference between the first flow rate fr1 and the second flow rate fr2 exceeds the above-mentioned threshold flow rate.

In the lower field of Fig. 11, another example of the valve condition corresponding to the target flow-rate condition in the upper field of Fig. 11 is shown by a graph. In the graph of the valve condition in Fig. 11, the ordinate indicates a method of controlling the valve, and the abscissa indicates a position on the movement path MP. On the abscissa, similarly to the example of Fig. 5, the reference sign CL1 is denoted as fixed control, and the reference sign CL2 is denoted as feedback control.

According to the valve condition of the present example, it is defined that the feedback control for the adjustment valve 65 is to be executed in the points p01 to p04, p07 to p14, p17 to p20. Further, it is defined that the fixed control for the adjustment valve 65 is to be executed in the points p05, p06, p15, p16.

According to this valve condition, the fixed control for the adjustment valve 65 is locally executed in a portion of the movement path MP where the target flow rate largely changes. Therefore, even in a case in which the nozzle 40 moves at a relatively high speed between two portions having different target flow rates, an appropriate amount of the processing liquid is likely to be supplied to the two portions and their vicinities.

Further, according to this valve condition, the feedback control for the adjustment valve 65 is executed in a portion where the target flow rate does not change. Therefore, in the portion where the target flow rate does not change, the chemical liquid can be supplied onto the substrate W with high accuracy.

### 8. Yet Another Example of Valve Condition

### (1) Valve Condition

In the above-mentioned "3. Various Conditions Used in Etching Process," description was made in regard to degradation of responsiveness of the flow-rate adjustment of the chemical liquid with the feedback control as a general theory in order to compare the feedback control and the fixed control to each other in regard to the responsiveness of the flow-rate adjustment of a chemical liquid.

On the other hand, as the feedback control, there is a control method using a plurality of control parameters. As such a control method, there is Proportional Integral Derivative (PID) control. With the PID control, output control is executed to bring the state of an object to be controlled close to a target state based on a proportional parameter, an integral parameter and a derivative parameter.

Here, each of a proportional parameter, an integral parameter and a derivative parameter influences a change in state of an object to be controlled. Therefore, in a case in which the PID control for the adjustment valve 65 is executed, it is considered that the responsiveness of the flow-rate adjustment of the chemical liquid can be enhanced depending on each value of a proportional parameter, an integral parameter and a derivative parameter, and the combination thereof.

The inventors of the present disclosure performed a second comparative test, described below, using the substrate processing apparatus 1 of Fig. 1 in order to compare the flow-rate changes of the chemical liquid by the two types of PID control using different control parameters.

First, the inventors of the present disclosure created one group of parameters including a first proportional parameter "α1," a first integral parameter "β1" and a first derivative parameter "y1" as a first parameter group. Further, the inventors of the present disclosure created another group of parameters including a second proportional parameter "α2," a second integral parameter "β2" and a first derivative parameter "γ2" as a second parameter group. The combination of the plurality of parameters in the first parameter group and the combination of the plurality of parameters in the second parameter group are different from each other.

Next, the inventors of the present disclosure caused the pump 63 to work, put the open-close valve 64 in an open state, and adjusted the opening of the adjustment valve 65 such that the detection result of the flow-rate sensor 66 was about 250 ml/min. Thereafter, the inventors of the present disclosure executed the PID control on the adjustment valve 65 using the first parameter group to increase the flow rate of the chemical liquid flowing downstream of the adjustment valve 65 from about 250 ml/min to 2000 ml/min. Further, the inventors of the present disclosure recorded the detection result of the flow-rate sensor 66 then. In the following description, the PID control using the first parameter group is referred to as first PID control.

Subsequently, the inventors of the present disclosure re-adjusted the opening of the adjustment valve 65 such that the detection result of the flow-rate sensor 66 was about 250 ml/min. Thereafter, the inventors of the present disclosure executed the PID control on the adjustment valve 65 using the second parameter group to increase the flow rate of the chemical liquid flowing downstream of the adjustment valve 65 from about 250 ml/min to 2000 ml/min. Further, the inventors of the present disclosure recorded the detection result of the flow-rate sensor 66 then. In the following description, the PID control using the second parameter group is referred to as second PID control.

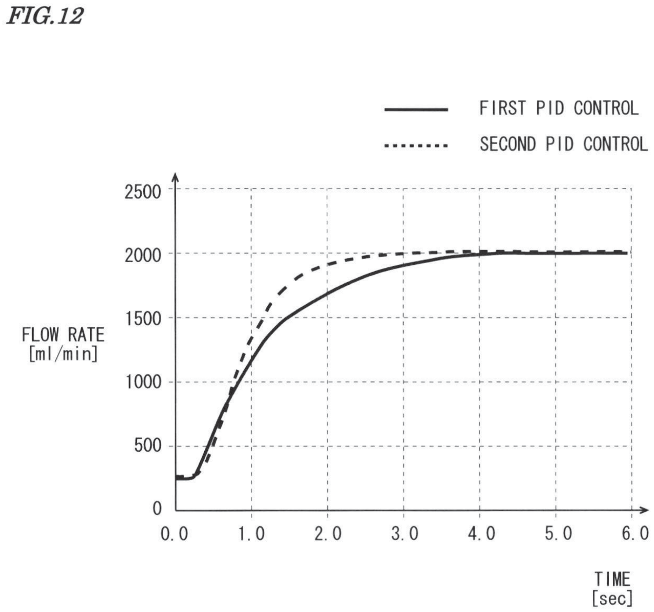

Fig. 12 is a diagram showing the result of the second comparative test. In Fig. 12, the ordinate indicates the flow rate of the chemical liquid flowing downstream of the adjustment valve 65, and the abscissa indicates the time. Further in Fig. 12, the change in flow rate of the chemical liquid when the flow rate of the chemical liquid discharged from the nozzle 40 is increased from about 250 ml/min to 2000 ml/min by the first PID control is indicated by the thick solid line. On the other hand, the flow rate of the chemical liquid discharged from the nozzle 40 is increased from about 250 ml/min to 2000 ml/min by the second PID control is indicated by the thick dotted line.

As shown in Fig. 12, with the first PID control, it requires about 4 seconds to increase the flow rate of the chemical liquid from about 250 ml/min to 2000 ml/min. In contrast, with the second PID control, it takes about 2.5 seconds to increase the flow rate of the chemical liquid from about 250 ml/min to 2000 ml/min. As is apparent from this result, the responsiveness of the flow-rate adjustment of the chemical liquid can be adjusted by a plurality of types of PID control for the adjustment valve 65 using different control parameters.

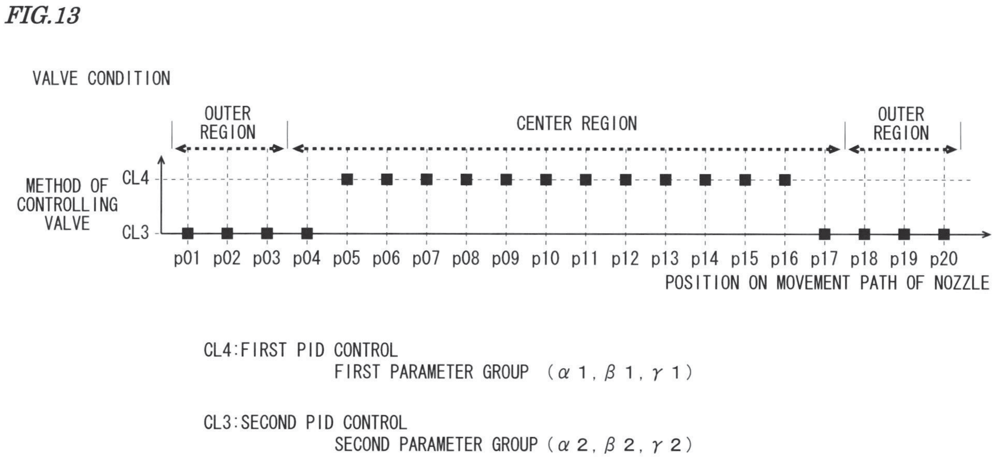

As such, the valve condition for controlling the adjustment valve 65 using the plurality of types of PID control with different control parameters will be described. Fig. 13 is a diagram for explaining yet another example of the valve condition. In Fig. 13, another example of the valve condition corresponding to the target flow-rate condition of Fig. 4 is shown by a graph. In the valve condition of the present example, the first PID control and the second PID control, described above, are used as a plurality of types of control for the adjustment valve 65.

In the graph of the valve condition in Fig. 13, the ordinate indicates a method of controlling the valve, and the abscissa indicates a position on the movement path MP. On the ordinate, a reference sign CL3 is denoted as the second PID control, and a reference sign CL4 is denoted as the first PID control.

In the valve condition of the present example, it is defined that the second PID control for the adjustment valve 65 is to be executed in the points p01 to p04, p17 to p20. Further, it is defined that the first PID control for the adjustment valve 65 is to be executed in the points p05 to p16.

According to the valve condition of the present example, when the target flow rate changes between the first flow rate fr1 and the second flow rate fr2 in the outer region R2 of the substrate W, the second PID control for the adjustment valve 65 is executed. As shown in the result of the second comparative test of Fig. 12, the second PID control for the adjustment valve 65 enhances the responsiveness of the flow-rate adjustment of the chemical liquid as compared with the first PID control for the adjustment valve 65. Thus, as compared with a case in which the first PID control for the adjustment valve 65 is executed in the points p01 to p04, p17 to p20, the flow rate of the chemical liquid discharged from the nozzle 40 is brought close to the target flow rate with high responsiveness.

### (2) Parameters of PID Control

The first parameter group (α1, β1, γ1) of the above-mentioned first PID control is preferably defined for the purpose of adjusting the flow rate of the chemical liquid with higher accuracy. On the other hand, the second parameter group (α2, β2, γ2) of the second PID control is preferably defined for the purpose of enhancing the responsiveness of the flow-rate adjustment of the chemical liquid.

Based on these viewpoints, it is preferable that the second proportional parameter "α2" is set to a value smaller than the first proportional parameter "α1." Alternatively, it is preferable that the second integral parameter "β2" is preferably set to a value smaller than the first integral parameter "β1." Further, it is preferable that the first derivative parameter "y1" and the second derivative parameter "y2" are set to the same value.

With the PID control, when a proportional parameter is set to a small value, hunting is likely to occur in the output. On the other hand, when a proportional parameter is set to a large value, a period of time required until the output reaches a target value is increased. Further, when an integral parameter is set to a small value, hunting is likely to occur in the output. On the other hand, when an integral parameter is set to a large value, a period of time required until the output reaches a target value is increased. Further, when a derivative parameter is set to a small value, a period of time required until the output reaches the target value is reduced. On the other hand, when a derivative parameter is set to a large value, a period of time required until the output reaches a target value is increased.

Therefore, it is preferable that the first parameter group (α1, β1, γ1) and the second parameter group (α2, β2, γ2) are defined in consideration of the characteristics of each parameter and a flow-rate change amount.

### 9. Substrate Processing System Including Substrate Processing Apparatus 1

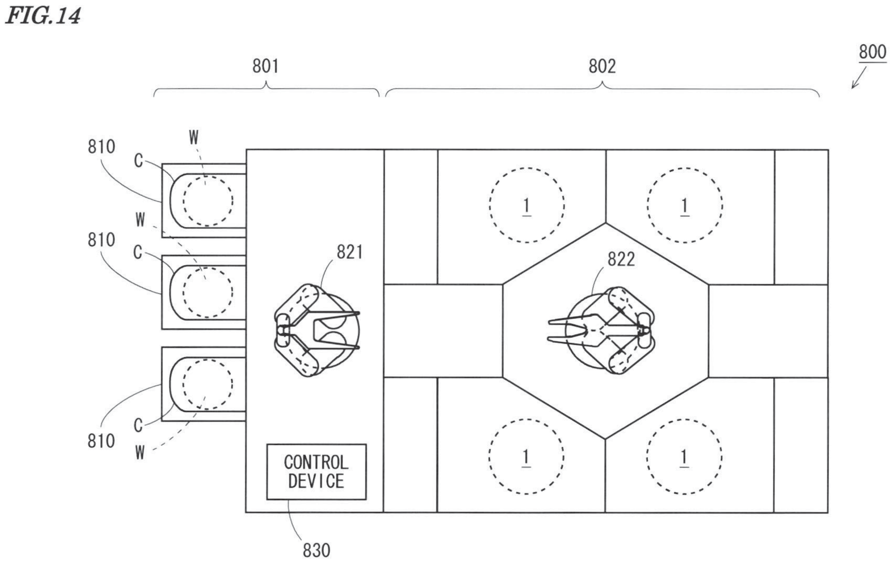

Fig. 14 is a schematic plan view showing one example of a substrate processing system including the substrate processing apparatus 1 of Fig. 1. As shown in Fig. 14, the substrate processing system 800 of the present example includes a substrate carry-in carry-out section 801 and a substrate processing section 802.

In the substrate carry-in carry-out section 801, a plurality (three in the present example) of carrier platforms 810, a transport robot 821 and a control device 830 are provided. In each carrier platform 810, a carrier C for storing a plurality of substrates W is placed. The transport robot 821 includes a plurality (four, for example) of hands, and is configured to be capable of holding and transporting a substrate W. The control device 830 includes a CPU and a memory, or a microcomputer, and controls each constituent element of the substrate processing system 800.

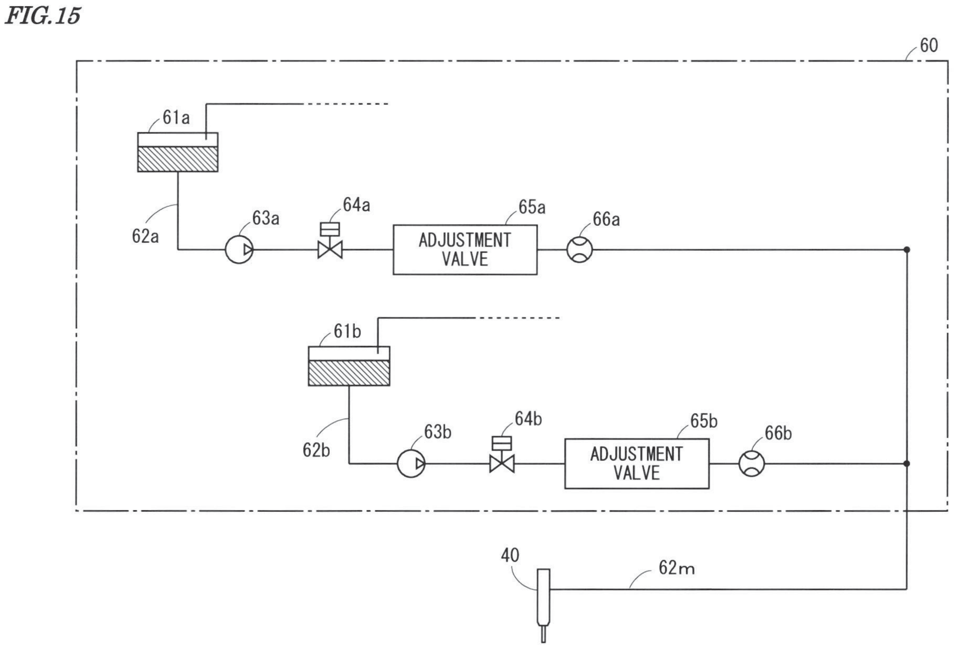

In the substrate processing section 802, a transport robot 822 and a plurality (four in the present example) of substrate processing apparatuses 1 are provided. In plan view, the four substrate processing apparatuses 1 are arranged to surround the transport robot 822. Each of these substrate processing apparatuses 1 is the substrate processing apparatus 1 of Fig. 1. That is, in the substrate processing system 800 of Fig. 15, the substrate processing apparatus 1 of Fig. 1 is provided as one processing unit forming the substrate processing system 800. The transport robot 822 includes a plurality (four, for example) of hands, and is configured to be capable of holding and transporting a substrate W.

In the substrate processing system 800, the transport robot 821 takes out an unprocessed substrate W from any one of a plurality of carriers C placed on the plurality of carrier platforms 810, and transfers the unprocessed substrate W to the transport robot 822. The transport robot 822 transfers the received substrate W to one of the plurality of substrate processing apparatuses 1. Thus, the above-mentioned etching process is executed in the one substrate processing apparatus 1.

Further, the transport robot 822 takes out the processed substrate W from the one substrate processing apparatus 1 among the plurality of substrate processing apparatuses 1 and transfers the processed substrate W to the transport robot 821. The transport robot 821 receives the processed substrate W and accommodates the substrate W in an empty carrier C.

With each substrate processing apparatus 1, it is possible to execute a process on the substrate W with high accuracy while suppressing wasteful consumption of the chemical liquid. Therefore, with the substrate processing system 800, wasteful consumption of the chemical liquid is further reduced. Further, the substrate process can be executed with high efficiency and high yield.

### 10. Other Embodiments

(a) While the chemical liquid used in the etching process for the substrate W is supplied from the liquid supply source 61 to the substrate W through the liquid flow path 62 and the nozzle 40 in the substrate processing apparatus 1 according to the above-mentioned embodiment, the present disclosure is not limited to this.

The chemical liquid discharged from the nozzle 40 to the substrate W may be generated by mixing of a plurality of processing liquids. In this case, the liquid supply system 60 may have a configuration for generating a chemical liquid used in the etching process for the substrate W by mixing a plurality of processing liquids.

Fig. 15 is a schematic diagram showing one example of a liquid supply system 60 according to another embodiment. In the present example, suppose that a chemical liquid used for the etching process for the substrate W is generated by mixing of two processing liquids.

The liquid supply system 60 of Fig. 15 includes liquid supply sources 61a, 61b, liquid flow paths 62a, 62b, 62m, pumps 63a, 63b, open-close valves 64a, 64b, adjustment valves 65a, 65b and flow-rate sensors 66a, 66b.

The liquid supply source 61a is a storage tank and is configured to be capable of storing a certain amount of a first processing liquid. The upstream end of the liquid flow path 62a is connected to the liquid supply source 61a. The liquid flow path 62a is mainly formed of one or a plurality of pipes.

The liquid supply source 61b is a storage tank and is configured to be capable of storing a certain amount of the first processing liquid. The upstream end of the liquid flow path 62b is connected to the liquid supply source 61b. The liquid flow path 62b is mainly formed of one or a plurality of pipes.

The liquid flow path 62m is provided so as to extend from the nozzle 40. The liquid flow path 62m is mainly formed of one or a plurality of pipes. The downstream ends of the two liquid flow paths 62a, 62b are connected to two portions of the liquid flow path 62m.

In the liquid flow path 62a, the pump 63a, the open-close valve 64a, the adjustment valve 65a and the flow-rate sensor 66a are provided to be arranged in this order from the upstream end toward the downstream end of the liquid flow path 62a. Also in the liquid flow path 62b, the pump 63b, the open-close valve 64b, the adjustment valve 65b and the flow-rate sensor 66b are provided to be arranged in this order from the upstream end toward the downstream end of the liquid flow path 62b.

The pumps 63a, 63b basically have the same configuration as the pump 63 according to the above-mentioned embodiment. The open-close valves 64a, 64b basically have the same configuration as the open-close valve 64 according to the above-mentioned embodiment. The adjustment valves 65a, 65b basically have the same configuration as the adjustment valve 65 according to the above-mentioned embodiment. The flow-rate sensors 66a, 66b basically have the same configuration as the flow-rate sensor 66 according to the above-mentioned embodiment.

In the liquid supply system 60 of the present example, during the etching process for the substrate W, the open-close valves 64a, 64b and the adjustment valves 65a, 65b are mainly controlled. Thus, the first processing liquid is supplied from the liquid supply source 61a to the liquid flow path 62m through the liquid flow path 62a. Further, the second processing liquid is supplied from the liquid supply source 61b to the liquid flow path 62m through the liquid flow path 62b. Further, in the liquid flow path 62m, the first processing liquid and the second processing liquid supplied from the liquid flow paths 62a, 62b are mixed, and a chemical liquid is generated. The generated chemical liquid is guided to the nozzle 40 to be discharged from the nozzle 40.

Here, in order to prevent variations in composition of the chemical liquid that is used during the etching process, the flow rate of the first processing liquid and the flow rate of the second processing liquid respectively flowing through the liquid flow paths 62a, 62b need to be accurately adjusted.

Therefore, in a case in which the liquid supply system 60 includes the plurality of liquid flow paths 62a, 62b and the plurality of adjustment valves 65a, 65b corresponding to a plurality of processing liquids, it is preferable that the target flow condition and the valve condition, described above, are defined for each processing liquid. Specifically, in regard to the example of Fig. 15, it is preferable that the target flow-rate condition and the valve condition corresponding to the first processing liquid are defined, and that the target flow-rate condition and the valve condition corresponding to the second processing liquid are defined.

(b) The substrate processing apparatus 1 according to the above-mentioned embodiment is an etching device that mainly executes the etching process on the substrate W, the present disclosure is not limited to this. The substrate processing apparatus 1 may be a coating processing device that supplies a coating liquid to the upper surface of the substrate W.

In this case, the coating liquid for forming a resist film, an anti-reflection film or the like is supplied as a processing liquid to the upper surface of the substrate W held by the substrate holding device 10. Therefore, in the substrate processing apparatus 1, a coating liquid supply system corresponding to the liquid supply system 60 of Fig. 1 is provided.

Therefore, by defining a nozzle movement condition, a target flow-rate condition, a valve condition and a basic work condition corresponding to the coating liquid supply system and executing the coating process based on these conditions, it is possible to obtain the same effects as those of the above-mentioned embodiment.

(c) While the substrate processing apparatus 1 according to the above-mentioned embodiment is an etching device that mainly executes the etching process on the substrate W, the present disclosure is not limited to this. The substrate processing apparatus 1 may be a substrate processing apparatus that replaces a chemical liquid remaining on the upper surface of the substrate W after the etching process and cleans the substrate W.

In this case, after the etching process for the substrate W, a replacement liquid and a cleaning liquid are sequentially supplied as processing liquids to the upper surface of the substrate W held by the substrate holding device 10. Therefore, in addition to the liquid supply system 60 of Fig. 1, in the substrate processing apparatus 1, a replacement liquid supply system and a cleaning liquid supply system corresponding to the liquid supply system 60 are further provided.

Therefore, by defining a nozzle movement condition, a target flow-rate condition, a valve condition and a basic work condition corresponding to each of the replacement liquid supply system and the cleaning liquid supply system and executing each process based on these conditions, it is possible to obtain the similar effects as those of the above-mentioned embodiment.

When the replacement liquid and the cleaning liquid are supplied to the substrate W, a target flow-rate condition may be defined such that the flow rate of the processing liquid to be supplied to the center region R1 of the upper surface of the substrate W is larger than the flow rate of the processing liquid to be supplied to the outer region R2 of the upper surface of the substrate W.

(d) In the substrate processing apparatus 1 according to the above-mentioned embodiment, the adjustment valve 65 is controlled by the two types of control methods during execution of the etching process for the substrate W. However, the present disclosure is not limited to this.

The number of types of methods of controlling the adjustment valve 65 executed during the etching process for the substrate W may be three or more. For example, the substrate processing apparatus 1 may switch among the fixed control, the first PID control and the second PID control to execute the control on the adjustment valve 65 during the etching process for one substrate W.

(e) In the nozzle movement condition according to the above-mentioned embodiment, a plurality of movement speeds are defined so as to respectively correspond to the plurality of points p01 to p20 on the movement path MP. Further, in the target flow-rate condition, the plurality of target flow rates are defined so as to respectively correspond to the plurality of points p01 to p20 on the movement path MP. Further, in the valve condition, the plurality of control methods are defined so as to respectively correspond to the plurality of points p01 to p20 on the movement path MP. However, the present disclosure is not limited to these.

(e) In a nozzle movement condition, a plurality of movement speeds are defined so as to respectively correspond to a plurality of portions (range) on the movement path MP. In a target flow rate condition, a plurality of target flow rates may be defined so as to respectively correspond to a plurality of portions (ranges) of the movement path MP. In a valve condition, a plurality of control methods may be defined so as to respectively correspond to a plurality of portions (ranges) of the movement path MP.

(f) While the substrate holding device 10 has a so-called mechanical chuck-type configuration that holds the substrate W by abutment of the plurality of holding pins 11b against the outer peripheral end of the substrate W in the substrate processing apparatus 1 according to the above-mentioned embodiment, the present disclosure is not limited to this. The substrate holding device 10 may have a suction-type configuration that holds the center portion of the lower surface of the substrate W by suction.

### 11. Correspondences between Constituent Elements in Claims and Parts in Preferred Embodiments

In the following paragraphs, non-limiting examples of correspondences between various elements recited in the claims below and those described above with respect to various preferred embodiments of the present disclosure are explained. As each of various elements recited in the claims, various other elements having configurations or functions described in the claims can be also used.

In the above-mentioned embodiment, the substrate holder 11 is an example of a substrate holder, the chemical liquid, the first processing liquid, the second processing liquid, the coating liquid, the replacement liquid and the cleaning liquid are examples of a processing liquid, the nozzle 40 is an example of a nozzle, the liquid flow paths 62, 62a, 62b are examples of a liquid flow path, the adjustment valve 65 is an example of a valve, the liquid supply system 60 is an example of a processing liquid supply system, and the substrate processing apparatus 1 and the substrate processing system 800 are examples of a substrate processing apparatus.

Further, the nozzle movement device 50 is an example of a movement driver, the controller 90 is an example of a controller, the feedback control and the first PID control associated with a portion of the substrate W (a portion of the movement path MP) in the valve condition are examples of first valve control information, and the fixed control and the second PID control associated with another portion of the substrate W (another portion of the movement path MP) in the valve condition are examples of second valve control information.

Further, the center region R1 is an example of a center region, the outer region R2 is an example of an outer region, the threshold flow rate is an example of a threshold value, the horizontal-direction driver 52 and the horizontal movement controller 916 are examples of a nozzle position acquirer, the flow-rate sensor 66 is an example of a flow-rate detector, the first parameter group is an example of a first control parameter, the second parameter group is an example of a second control parameter, the portions of the substrate W respectively corresponding to the points p03, p18 on the movement path MP in Fig. 2 are examples of a first portion, and the portions of the substrate W respectively corresponding to the points p02, p19 on the movement path MP in Fig. 2 are examples of a second portion.

### 12. Overview of Embodiments

(Item 1) A substrate processing apparatus according to item 1 includes a substrate holder that holds and rotates a substrate, a nozzle that downwardly discharges a processing liquid, a processing liquid supply system that includes a liquid flow path and a valve and supplies the processing liquid to the nozzle, the liquid flow path being connected to the nozzle, the valve adjusting a flow rate of the processing liquid flowing through the liquid flow path, a movement driver that moves the nozzle to a plurality of different portions in a radial direction on an upper surface of the substrate while maintaining the nozzle above the substrate held by the substrate holder, and a controller that controls the movement driver based on a nozzle movement condition, and controls the valve based on a valve condition, wherein the nozzle movement condition includes a plurality of portion movement information pieces, the plurality of portion movement information pieces defining movement speeds of the nozzle when the nozzle moves through the plurality of respective portions for supply of the processing liquid to the plurality of respective portions of the substrate, the valve condition includes a plurality of valve control information pieces representing methods of controlling the valve when the nozzle moves through the plurality of respective portions, and the plurality of valve control information pieces include first valve control information corresponding to one portion of the plurality of portions of the substrate, and the second valve control information that corresponds to another portion of the plurality of portions of the substrate and is different from the first valve control information.

In the substrate processing apparatus, the nozzle moves through the plurality of portions of the substrate held by the substrate holder. Further, the processing liquid is supplied to the nozzle through the liquid flow path. Thus, the processing liquid is supplied to the plurality of portions of the upper surface of the substrate, and the substrate is processed.

In the above-mentioned process, it is preferable that the processing liquid is supplied to each of the plurality of portions of the substrate at an appropriate point in time in order to improve the uniformity of the process, for example. As such, in the above-mentioned substrate processing apparatus, the movement speed of the nozzle is adjusted in the plurality of portions of the substrate based on the nozzle movement condition.

Further, in each of the plurality of portions of the substrate, it is preferable that an appropriate amount of the processing liquid is supplied for the process for the portion. However, depending on the type of the processing liquid, an amount of the processing liquid to be supplied to each of the plurality of portions of the substrate, and the movement speed of the nozzle when the nozzle moves through each of the plurality of portions of the substrate, an appropriate amount of the processing liquid may not be supplied to the plurality of portions of the substrate due to the method of controlling the valve.

As such, in the above-mentioned substrate processing apparatus, the valve is controlled based on the first valve control information in one portion of the plurality of portions of the substrate. Further, the valve is controlled based on the second valve control information different from the first valve control information in another portion of the plurality of portions of the substrate. Therefore, it is possible to supply an appropriate amount of the processing liquid to the plurality of portions of the substrate by appropriately setting the first valve control information and the second valve control information. In other words, the different methods of controlling the valve can be used for the plurality of portions of the substrate according to the movement speeds of the nozzle when the nozzle moves through the plurality of portions of the substrate, and amounts of the processing liquid to be discharged from the nozzle.

Thus, because an appropriate amount of the processing liquid can be appropriately supplied to the plurality of portions of the substrate, it is possible to execute a process on the substrate with high accuracy while reducing wasteful consumption of the processing liquid.

(Item 2) The substrate processing apparatus according to item 1, may further include a nozzle position acquirer that acquires a position of the nozzle with respect to the substrate, and a flow-rate detector that detects a flow rate of the processing liquid flowing through the liquid flow path, wherein a flow rate of the processing liquid to flow through the liquid flow path when the nozzle moves through each portion of the plurality of portions of the substrate may be defined as a target flow rate corresponding to the each portion, and the first valve control information may include information representing that feedback control is to be executed, with the feedback control adjusting an opening of the valve based on detection results of the flow-rate detector and the nozzle position acquirer such that a flow rate of the processing liquid flowing through the liquid flow path is brought close to a target flow rate corresponding to a position detected by the nozzle position acquirer, and the second valve control information may include information representing that fixed control is to be executed, with the fixed control fixing an opening of the valve to a predetermined prescribed opening.

In this case, with the first valve control information, the feedback control is executed on an opening of the valve. Thus, it is possible to supply an amount of the processing liquid to be supplied to the portion with high accuracy, to each of the plurality of portions of the substrate.

On the other hand, with the second valve control information, the fixed control is executed on the valve. In a case in which the fixed control for the valve is executed, the responsiveness of the flow-rate change of the processing liquid flowing through the liquid flow path is enhanced as compared with a case in which the feedback control is executed based on the first valve control information.

Two target flow rates may be associated with two adjacent portions out of the plurality of portions of the substrate, with the difference between the two target flow rates being relatively large. As described above, with the second valve control information, the responsiveness of the flow-rate change of the processing liquid discharged from the nozzle is enhanced. Therefore, in a case in which the nozzle moves through such two portions, because the valve is controlled based on the second valve control information, the flow rate of the processing liquid discharged from the nozzle is easily adjusted according to the movement speed of the nozzle.

(Item 3) The substrate processing apparatus according to item 2, wherein the upper surface of the substrate may include a center region which includes a center portion of the substrate and in which a circuit pattern is formed or scheduled to be formed, and an outer region including a first portion, a second portion and an outer peripheral end of the substrate and surrounding the center region of the substrate, with the first portion and the second portion being arranged in the radial direction from a center of the substrate toward an outward position of the substrate, a target flow rate corresponding to the second portion of the substrate may be lower than a target flow rate corresponding to the center region of the substrate and the first portion of the substrate, the first valve control information may be valve control information representing a method of controlling the valve when the nozzle moves through at least one portion of the center region, the second valve control information may be valve control information representing a method of controlling the valve when the nozzle moves through the outer region, and the prescribed opening may be set to an opening of the valve at which a flow rate of the processing liquid flowing through the liquid flow path is estimated to coincide with a target flow rate corresponding to a position detected by the nozzle position acquirer.

In the center region of the substrate, a circuit pattern is formed or scheduled to be formed. Therefore, in the center region of the substrate, a process using the processing liquid is fundamentally required to be executed with high accuracy. On the other hand, in the outer region of the substrate, a circuit pattern is not formed or not scheduled to be formed. Therefore, the outer region of the substrate is fundamentally not to be processed using the processing liquid.

With the above-mentioned configuration, the target flow rate corresponding to the center region of the substrate and the first portion of the substrate is higher than the target flow rate corresponding to the second portion of the substrate. Further, when the nozzle moves through at least a portion of the center region of the substrate W, the feedback control is executed on the valve. Thus, an amount of the processing liquid required for the etching process is likely to be supplied to the center region of the substrate W with high accuracy. Therefore, the center region of the substrate is processed with high accuracy.

On the other hand, when the nozzle moves through the outer region of the substrate, the fixed control is executed on the valve. In this case, because the target flow rate corresponding to the second portion of the substrate is lower than the target flow rate corresponding to the center region and the first portion of the substrate, an amount of the processing liquid supplied to the outer region of the substrate is reduced by setting of the valve to a prescribed opening. In other words, an excessive amount of the processing liquid is prevented from being supplied to a region in the substrate where a circuit pattern is not formed.

Further, the fixed control enhances the responsiveness of the flow-rate change of the processing liquid flowing through the liquid flow path as compared with the feedback control. Therefore, when the nozzle continuously moves through the first portion and the second portion, a large response delay is unlikely to occur in regard to the flow rate of the chemical liquid supplied to the substrate. As a result, it suppresses a large deviation of the flow rate of the processing liquid supplied to the center region of the substrate from the target flow rate. Further, in the outer region of the substrate, wasteful consumption of the processing liquid is suppressed.

In regard to the outer region of the substrate, it is not necessary to accurately match an amount of the processing liquid supplied to the substrate with the target flow rate. This is because the outer region of the substrate is a region in which a circuit pattern is not formed, and it is not necessary to strictly manage the supply flow rate of the processing liquid.

(Item 4) The substrate processing apparatus according to item 2, wherein the plurality of portions of the substrate may be arranged on a virtual line, with the virtual line passing through a center of the substrate from one portion in an outer peripheral end of the substrate to another portion in the outer peripheral end of the substrate in plan view, and the second valve control information may be valve control information representing a method of controlling the valve when, in a case in which a difference between two target flow rates respectively corresponding to two adjacent portions of the plurality of portions arranged on the virtual line of the substrate exceeds a predetermined threshold value, the nozzle moves through the two portions.

The fixed control enhances the responsiveness of the flow-rate change of the processing liquid flowing through the liquid flow path as compared with the feedback control. Therefore, with the above-mentioned configuration, even in a case in which the nozzle moves at a relatively high speed between the two portions having different target flow rates, an appropriate amount of the processing liquid is likely to be supplied to the two portions and their vicinities.

(Item 5) The substrate processing apparatus according to item 1, may further include a nozzle position acquirer that acquires a position of the nozzle on the substrate, and a flow-rate detector that detects a flow rate of the processing liquid flowing through the liquid flow path, wherein a flow rate of the processing liquid to flow through the liquid flow path when the nozzle moves through each portion of the plurality of portions of the substrate may be defined as a target flow rate corresponding to the each portion, and the first valve control information may include information representing that first feedback control is to be executed, with the first feedback control adjusting an opening of the valve based on a predetermined first control parameter, and detection results of the flow-rate detector and the nozzle position acquirer, such that a flow rate of the processing liquid flowing through the liquid flow path is brought close to a target flow rate corresponding to a position detected by the nozzle position acquirer, the second valve control information may include information representing that second feedback control is to be executed, with the second feedback control adjusting an opening of the valve based on a predetermined second control parameter, and detection results of the flow-rate detector and the nozzle position acquirer, such that a flow rate of the processing liquid flowing through the liquid flow path is brought close to a target flow rate corresponding to a position detected by the nozzle position acquirer, and the first control parameter and the second control parameter may be different from each other.

In this case, the method of controlling the valve is switched between the first feedback control and the second feedback control in a period during which the nozzle moves through the plurality of portions of the substrate. The first feedback control is based on the first control parameter, and the second feedback control is based on the second control parameter different from the first control parameter. Therefore, it is possible to supply an appropriate amount of the processing liquid to the plurality of portions of the substrate by appropriately setting the first control parameter and the second control parameter.

(Item 6) A substrate processing method according to item 6 of processing a substrate using a substrate processing apparatus, wherein the substrate processing apparatus includes a nozzle that downwardly discharges a processing liquid, a liquid flow path connected to the nozzle, and a valve that adjusts a flow rate of the processing liquid flowing through the liquid flow path, the substrate processing method includes holding and rotating the substrate using a substrate holder, based on a nozzle movement condition, moving the nozzle to a plurality of different portions in a radial direction on an upper surface of the substrate while maintaining the nozzle above the substrate held by the substrate holder, and based on a valve condition, adjusting a flow rate of the processing liquid flowing through the liquid flow path to the nozzle, the nozzle movement condition includes a plurality of portion movement information pieces, with the plurality of portion movement information pieces defining movement speeds of the nozzle when the nozzle moves through the plurality of respective portions of the substrate for supply of the processing liquid to the plurality of respective portions of the substrate, the valve condition includes a plurality of valve control information pieces representing methods of controlling the valve when the nozzle moves through the plurality of respective portions, and the plurality of valve control information pieces include first valve control information corresponding to one portion of the plurality of portions of the substrate, and second valve control information that corresponds to another portion of the plurality of portions of the substrate and is different from the first valve control information.

With the substrate processing method, the nozzle moves through the plurality of portions of the substrate held by the substrate holder. Further, the processing liquid is supplied to the nozzle through the liquid flow path. Thus, the processing liquid is supplied to the plurality of portions of the upper surface of the substrate, and the substrate is processed.

In the above-mentioned process, it is preferable that the processing liquid is supplied to the plurality of portions of the substrate at respective appropriate points in time in order to improve the uniformity of the process, for example. As such, with the above-mentioned substrate processing method, the movement speed of the nozzle is adjusted in each of the plurality of portions of the substrate based on the nozzle movement condition.

Further, in each of the plurality of portions of the substrate, it is preferable that an appropriate amount of the processing liquid is supplied for the process for the portion. However, depending on the type of the processing liquid, an amount of the processing liquid to be supplied to each of the plurality of portions of the substrate, and the movement speed of the nozzle when the nozzle moves through each of the plurality of portions of the substrate, an appropriate amount of the processing liquid may not be supplied to the plurality of portions of the substrate due to the method of controlling the valve.

As such, with the above-mentioned substrate processing method, the valve is controlled based on the first valve control information for a portion of the plurality of portions of the substrate. Further, the valve is controlled based on the second valve control information different from the first valve control information for another portion of the plurality of portions of the substrate. Therefore, it is possible to supply an appropriate amount of the processing liquid to the plurality of portions of the substrate by appropriately setting the first valve control information and the second valve control information. In other words, the different methods of controlling the valve can be used for the plurality of portions of the substrate according to the movement speeds of the nozzle when the nozzle moves through the plurality of portions of the substrate, and amounts of the processing liquid to be discharged from the nozzle.

Thus, because an appropriate amount of the processing liquid can be appropriately supplied to the plurality of portions of the substrate, it is possible to execute a process on the substrate with high accuracy while reducing wasteful consumption of the processing liquid.

While preferred embodiments of the present disclosure have been described above, it is to be understood that variations and modifications will be apparent to those skilled in the art without departing the scope and spirit of the present disclosure. The scope of the present disclosure, therefore, is to be determined solely by the following claims.

## Claims

1. A substrate processing apparatus comprising:
a substrate holder that holds and rotates a substrate;
a nozzle that downwardly discharges a processing liquid;
a processing liquid supply system that includes a liquid flow path and a valve and supplies the processing liquid to the nozzle, the liquid flow path being connected to the nozzle, the valve adjusting a flow rate of the processing liquid flowing through the liquid flow path;
a movement driver that moves the nozzle to a plurality of different portions in a radial direction on an upper surface of the substrate while maintaining the nozzle above the substrate held by the substrate holder; and
a controller that controls the movement driver based on a nozzle movement condition, and controls the valve based on a valve condition, wherein
the nozzle movement condition includes a plurality of portion movement information pieces, the plurality of portion movement information pieces defining movement speeds of the nozzle when the nozzle moves through the plurality of respective portions for supply of the processing liquid to the plurality of respective portions of the substrate,
the valve condition includes a plurality of valve control information pieces representing methods of controlling the valve when the nozzle moves through the plurality of respective portions, and
the plurality of valve control information pieces include
first valve control information corresponding to one portion of the plurality of portions of the substrate, and
the second valve control information that corresponds to another portion of the plurality of portions of the substrate and is different from the first valve control information.

2. The substrate processing apparatus according to claim 1, further comprising:
a nozzle position acquirer that acquires a position of the nozzle with respect to the substrate; and
a flow-rate detector that detects a flow rate of the processing liquid flowing through the liquid flow path, wherein
a flow rate of the processing liquid to flow through the liquid flow path when the nozzle moves through each portion of the plurality of portions of the substrate is defined as a target flow rate corresponding to the each portion, and
the first valve control information includes information representing that feedback control is to be executed, with the feedback control adjusting an opening of the valve based on detection results of the flow-rate detector and the nozzle position acquirer such that a flow rate of the processing liquid flowing through the liquid flow path is brought close to a target flow rate corresponding to a position detected by the nozzle position acquirer, and
the second valve control information includes information representing that fixed control is to be executed, with the fixed control fixing an opening of the valve to a predetermined prescribed opening.

3. The substrate processing apparatus according to claim 2, wherein
the upper surface of the substrate includes
a center region which includes a center portion of the substrate and in which a circuit pattern is formed or scheduled to be formed, and
an outer region including a first portion, a second portion and an outer peripheral end of the substrate and surrounding the center region of the substrate, with the first portion and the second portion being arranged in the radial direction from a center of the substrate toward an outward position of the substrate,
a target flow rate corresponding to the second portion of the substrate is lower than a target flow rate corresponding to the center region of the substrate and the first portion of the substrate,
the first valve control information is valve control information representing a method of controlling the valve when the nozzle moves through at least one portion of the center region,
the second valve control information is valve control information representing a method of controlling the valve when the nozzle moves through the outer region, and
the prescribed opening is set to an opening of the valve at which a flow rate of the processing liquid flowing through the liquid flow path is estimated to coincide with a target flow rate corresponding to a position detected by the nozzle position acquirer.

4. The substrate processing apparatus according to claim 2, wherein
the plurality of portions of the substrate are arranged on a virtual line, with the virtual line passing through a center of the substrate from one portion in an outer peripheral end of the substrate to another portion in the outer peripheral end of the substrate in plan view, and
the second valve control information is valve control information representing a method of controlling the valve when, in a case in which a difference between two target flow rates respectively corresponding to two adjacent portions of the plurality of portions arranged on the virtual line of the substrate exceeds a predetermined threshold value, the nozzle moves through the two portions.

5. The substrate processing apparatus according to claim 1, further comprising:
a nozzle position acquirer that acquires a position of the nozzle on the substrate; and
a flow-rate detector that detects a flow rate of the processing liquid flowing through the liquid flow path, wherein
a flow rate of the processing liquid to flow through the liquid flow path when the nozzle moves through each portion of the plurality of portions of the substrate is defined as a target flow rate corresponding to the each portion, and
the first valve control information includes information representing that first feedback control is to be executed, with the first feedback control adjusting an opening of the valve based on a predetermined first control parameter, and detection results of the flow-rate detector and the nozzle position acquirer, such that a flow rate of the processing liquid flowing through the liquid flow path is brought close to a target flow rate corresponding to a position detected by the nozzle position acquirer,
the second valve control information includes information representing that second feedback control is to be executed, with the second feedback control adjusting an opening of the valve based on a predetermined second control parameter, and detection results of the flow-rate detector and the nozzle position acquirer, such that a flow rate of the processing liquid flowing through the liquid flow path is brought close to a target flow rate corresponding to a position detected by the nozzle position acquirer, and
the first control parameter and the second control parameter are different from each other.

6. A substrate processing method of processing a substrate using a substrate processing apparatus,
the substrate processing apparatus including:
a nozzle that downwardly discharges a processing liquid;
a liquid flow path connected to the nozzle; and
a valve that adjusts a flow rate of the processing liquid flowing through the liquid flow path,
the substrate processing method including:
holding and rotating the substrate using a substrate holder;
based on a nozzle movement condition, moving the nozzle to a plurality of different portions in a radial direction on an upper surface of the substrate while maintaining the nozzle above the substrate held by the substrate holder; and
based on a valve condition, adjusting a flow rate of the processing liquid flowing through the liquid flow path to the nozzle, wherein
the nozzle movement condition includes a plurality of portion movement information pieces, with the plurality of portion movement information pieces defining movement speeds of the nozzle when the nozzle moves through the plurality of respective portions of the substrate for supply of the processing liquid to the plurality of respective portions of the substrate,
the valve condition includes a plurality of valve control information pieces representing methods of controlling the valve when the nozzle moves through the plurality of respective portions, and
the plurality of valve control information pieces include
first valve control information corresponding to one portion of the plurality of portions of the substrate, and
second valve control information that corresponds to another portion of the plurality of portions of the substrate and is different from the first valve control information.
